# EUROPEAN PATENT APPLICATION

(11) **EP 4 462 472 A1**
(43) Date of publication of application: **13.11.2024**
(21) Application number: 22922077.7
(22) Date of filing: 28.11.2022
(51) Int. Cl.: H01L 21/768, H01L 21/84, H01L 23/522, H01L 27/04, H01L 27/12, H01L 27/146

(54) **SEMICONDUCTOR DEVICE AND MANUFACTURING METHOD FOR SEMICONDUCTOR DEVICE**

(30) Priority: 21.01.2022 JP 2022007566
(71) Applicant: Sony Semiconductor Solutions Corporation, Atsugi-shi, Kanagawa 243-0014 (JP)
(72) Inventor: GOCHO, Tetsuo, Atsugi-shi, Kanagawa 243-0014 (JP)
(74) Representative: D Young & Co LLP
(86) International application number: PCT/JP2022/043674
(87) International publication number: WO 2023/139926

(57) **Abstract**

An increase in over-etching during forming of a through hole is reduced while a semiconductor substrate is thickened.

A semiconductor device includes a semiconductor layer, an insulating layer, a semiconductor substrate, a wiring layer, an insulating separation layer, a through electrode, and an insulating film. A semiconductor element is formed on the semiconductor layer. The semiconductor layer is laminated on the insulating layer. The insulating layer is laminated on the semiconductor substrate. The wiring layer is formed on the semiconductor layer. The insulating separation layer penetrates the semiconductor layer, reaches the insulating layer, and insulates and separates the semiconductor element. The through electrode penetrates the semiconductor substrate, the insulating layer, and the semiconductor layer, is connected to the wiring layer, and is surrounded by the insulating separation layer at a penetrating position of the semiconductor layer. The insulating film penetrates the semiconductor substrate, reaches the insulating layer, and is positioned between the semiconductor substrate and the through electrode.

## Description

### TECHNICAL FIELD

The present technology relates to a semiconductor device and a method of manufacturing a semiconductor device. Specifically, the present technology relates to a semiconductor device in which a through hole is included in a semiconductor substrate and a method for manufacturing a semiconductor device.

### BACKGROUND ART

In order to reduce the chip area of a semiconductor chip, a through electrode may be formed on a semiconductor substrate on which a semiconductor device is formed on the front surface side, and an electrode may be included on the back surface side of the semiconductor substrate. As a semiconductor device in which such a through electrode is formed, for example, a semiconductor device in which a first through electrode and a second through electrode are formed has been proposed. Here, the first through electrode penetrates a first semiconductor substrate and is connected to a wiring layer of the first semiconductor substrate. The second through electrode penetrates the first semiconductor substrate and the wiring layer thereof and is connected to a wiring layer of a second semiconductor substrate laminated on the first semiconductor substrate (see, for example, Patent Document 1).

### CITATION LIST

### PATENT DOCUMENT

Patent Document 1: Japanese Patent Application Laid-Open No. 2015-135938

### SUMMARY OF THE INVENTION

### PROBLEMS TO BE SOLVED BY THE INVENTION

However, in the above-described conventional technology, in order to maintain the mechanical strength of the semiconductor chip, over-etching during forming a through hole needs to be increased in a case where the semiconductor substrate is thickened. For this reason, the influence of charge due to dry etching during forming a through hole increases, and there has been a possibility that characteristic fluctuation of a transistor connected to a wiring layer occurs.

The present technology has been made in view of such a situation, and an object of the present technology is to reduce an increase in over-etching during forming a through hole while thickening a semiconductor substrate.

### SOLUTIONS TO PROBLEMS

The present technology has been made to solve the above-described issue, and a first aspect thereof is a semiconductor device including: a semiconductor layer on which a semiconductor element is formed; an insulating layer on which the semiconductor layer is laminated; a semiconductor substrate on which the insulating layer is laminated; a wiring layer formed on the semiconductor layer; an insulating separation layer that penetrates the semiconductor layer, reaches the insulating layer, and insulates and separates a part of the semiconductor layer; a through electrode that penetrates the semiconductor substrate, the insulating layer, and the semiconductor layer, is connected to the wiring layer, and is surrounded by the insulating separation layer at a penetrating position of the semiconductor layer; and an insulating film that penetrates the semiconductor substrate, reaches the insulating layer, and is positioned between the semiconductor substrate and the through electrode. This brings about an effect that over-etching of the semiconductor layer during forming the through hole in which the through electrode is embedded is reduced even in a case where the semiconductor substrate is thickened.

Furthermore, in the first aspect, the through electrode may be insulated from the semiconductor layer by the insulating separation layer and the insulating layer, and insulated from the semiconductor substrate by the insulating film and the insulating layer. This brings about an effect that the through electrode is embedded in the semiconductor layer and the semiconductor substrate while the semiconductor layer and the semiconductor substrate are insulated from the through electrode.

Furthermore, in the first aspect, an embedded wiring connected to the through electrode and embedded in the semiconductor layer in a state of being surrounded by the insulating separation layer may be further included. This brings about an effect that a wiring region is enlarged without the area of the semiconductor layer on which a semiconductor element is formed increased.

Furthermore, in the first aspect, a capacitive electrode connected to the through electrode and embedded in the semiconductor layer in a state of being surrounded by the insulating separation layer may be further included. This brings about an effect that capacitance is increased without the area of the semiconductor layer on which a semiconductor element is formed increased.

Furthermore, in the first aspect, a semiconductor chip in which a pixel is formed on a semiconductor substrate may be further included, a logic circuit that processes a pixel signal output from the pixel may be formed on the semiconductor layer, and the semiconductor chip may be laminated on the wiring layer. This brings about an effect that an image sensor function is added without the area of the semiconductor layer on which the logic circuit is formed increased.

Furthermore, in the first aspect, a material of the semiconductor layer and the semiconductor substrate may be Si. This brings about an effect that a selection ratio of etching of the insulating layer with respect to the semiconductor layer and the semiconductor substrate is secured.

Furthermore, in the first aspect, a material of the insulating layer may be SiO₂. This brings about an effect that etching is stopped at the position of the insulating layer during dry etching of the semiconductor substrate.

Furthermore, a second aspect is a method for manufacturing a semiconductor device, including: a step of forming an insulating separation layer that penetrates a semiconductor layer laminated on a semiconductor substrate with an insulating layer interposed between the semiconductor layer and the semiconductor substrate and reaches the insulating layer; a step of forming a semiconductor element on the semiconductor layer; a step of forming a first wiring layer connected to the semiconductor element on the semiconductor layer; a step of forming a first through hole that penetrates the semiconductor substrate and reaches the insulating layer in the semiconductor substrate; a step of forming an insulating film on a side wall of the first through hole; a step of forming a second through hole that reaches the semiconductor layer through the first through hole in the insulating layer; a step of forming a third through hole that reaches the first wiring layer through the first through hole and the second through hole in the semiconductor layer; and a step of embedding a through electrode surrounded by the insulating separation layer, the insulating layer, and the insulating film in the first through hole, the second through hole, and the third through hole. This brings about an effect that a semiconductor device in which over-etching during forming the third through hole is reduced even in a case where the semiconductor substrate is thickened.

Furthermore, in the second aspect, the first through hole may be formed in the semiconductor substrate on a basis of anisotropic etching, the second through hole may be formed in the insulating layer on a basis of anisotropic etching through the first through hole, and the third through hole may be formed in the semiconductor layer on a basis of isotropic etching through the first through hole and the second through hole. This brings about an effect that damage during forming the third through hole is reduced while the first through hole, the second through hole, and the third through hole are formed at positions of a mask pattern.

Furthermore, in the second aspect, a step of bonding a second wiring layer of a semiconductor chip in which the second wiring layer is formed on a semiconductor substrate on which a pixel is formed to the first wiring layer, and a step of thinning the semiconductor substrate from a surface opposite to a formation surface of the second wiring layer may be further included. This brings about an effect that a semiconductor device in which a back-irradiation solid-state imaging element is mounted on a logic circuit that performs signal processing of a pixel signal is manufactured.

### BRIEF DESCRIPTION OF DRAWINGS

Fig. 1 is a diagram illustrating a configuration example of a semiconductor device according to a first embodiment.
Fig. 2 is an enlarged cross-sectional view illustrating a specific example of a wiring layer of the semiconductor device according to the first embodiment.
Fig. 3 is a first diagram illustrating an example of a method of manufacturing the semiconductor device according to the first embodiment.
Fig. 4 is a second diagram illustrating an example of the method of manufacturing the semiconductor device according to the first embodiment.
Fig. 5 is a third diagram illustrating an example of the method of manufacturing the semiconductor device according to the first embodiment.
Fig. 6 is a fourth diagram illustrating an example of the method of manufacturing the semiconductor device according to the first embodiment.
Fig. 7 is a fifth diagram illustrating an example of the method of manufacturing the semiconductor device according to the first embodiment.
Fig. 8 is a diagram illustrating a configuration example of a semiconductor device according to a second embodiment.
Fig. 9 is a first diagram illustrating an example of a method of manufacturing the semiconductor device according to the second embodiment.
Fig. 10 is a second diagram illustrating an example of the method of manufacturing the semiconductor device according to the second embodiment.
Fig. 11 is a third diagram illustrating an example of the method of manufacturing the semiconductor device according to the second embodiment.
Fig. 12 is a fourth diagram illustrating an example of the method of manufacturing the semiconductor device according to the second embodiment.
Fig. 13 is a fifth diagram illustrating an example of the method of manufacturing the semiconductor device according to the second embodiment.
Fig. 14 is a sixth diagram illustrating an example of the method of manufacturing the semiconductor device according to the second embodiment.
Fig. 15 is a seventh diagram illustrating an example of the method of manufacturing the semiconductor device according to the second embodiment.
Fig. 16 is a diagram illustrating a configuration example of a semiconductor device according to a third embodiment.
Fig. 17 is a diagram illustrating a configuration example of a semiconductor device according to a fourth embodiment.
Fig. 18 is a diagram illustrating a configuration example of a semiconductor device according to a fifth embodiment.
Fig. 19 is a diagram illustrating a configuration example of a semiconductor device according to a sixth embodiment.
Fig. 20 is a diagram illustrating a configuration example of a semiconductor device according to a seventh embodiment.
Fig. 21 is a diagram illustrating a configuration example of a semiconductor device according to an eighth embodiment.
Fig. 22 is a diagram illustrating a configuration example of a semiconductor device according to a ninth embodiment.
Fig. 23 is a first diagram illustrating an example of a method of manufacturing the semiconductor device according to the ninth embodiment.
Fig. 24 is a second diagram illustrating an example of the method of manufacturing the semiconductor device according to the ninth embodiment.
Fig. 25 is a third diagram illustrating an example of the method of manufacturing the semiconductor device according to the ninth embodiment.
Fig. 26 is a fourth diagram illustrating an example of the method of manufacturing the semiconductor device according to the ninth embodiment.
Fig. 27 is a fifth diagram illustrating an example of the method of manufacturing the semiconductor device according to the ninth embodiment.
Fig. 28 is a sixth diagram illustrating an example of the method of manufacturing the semiconductor device according to the ninth embodiment.

### MODE FOR CARRYING OUT THE INVENTION

Hereinafter, modes for carrying out the present technology (hereinafter referred to as embodiments) will be described. The description will be given in the following order.
1. First embodiment (example in which a through electrode is included in a silicon on insulator (SOI) substrate that includes an insulating separation layer)
2. Second embodiment (example in which a through electrode and an embedded wiring are included in an SOI substrate that includes an insulating separation layer)
3. Third embodiment (example in which a through electrode and an embedded wiring are included in an SOI substrate that includes an insulating separation layer, and the through electrode and a projecting electrode are connected via a back surface wiring)
4. Fourth embodiment (example in which an embedded wiring embedded in an SOI substrate is single)
5. Fifth embodiment (example in which embedded wirings embedded in an SOI substrate are multi-wirings)
6. Sixth embodiment (example in which an embedded wiring embedded in an SOI substrate has a folded structure)
7. Seventh embodiment (example in which an embedded wiring embedded in an SOI substrate has a fishbone shape)
8. Eighth embodiment (example in which an embedded wiring embedded in an SOI substrate has a mesh shape)
9. Ninth embodiment (example in which capacitance is included in an SOI substrate that includes an insulating separation layer)

### <1. First Embodiment>

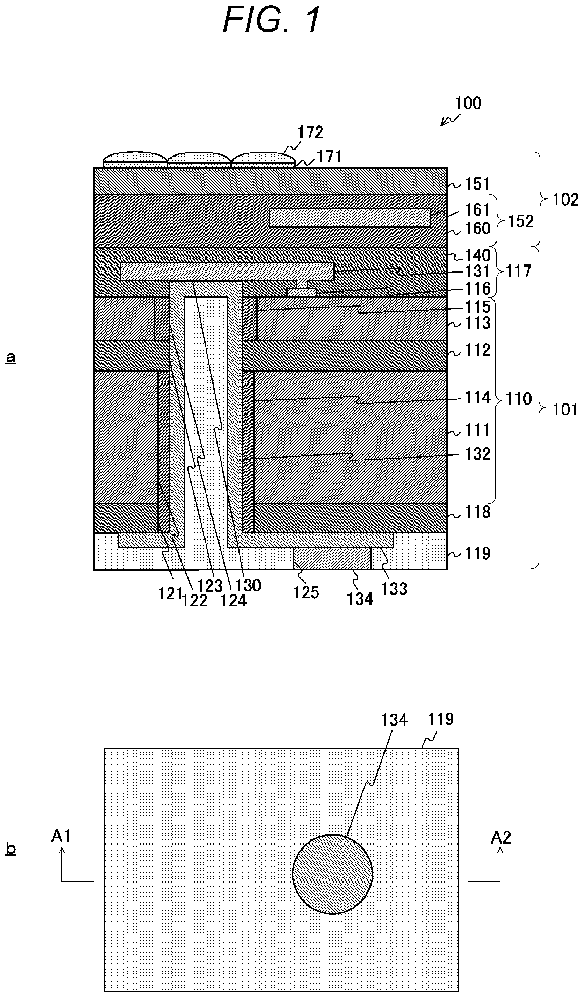

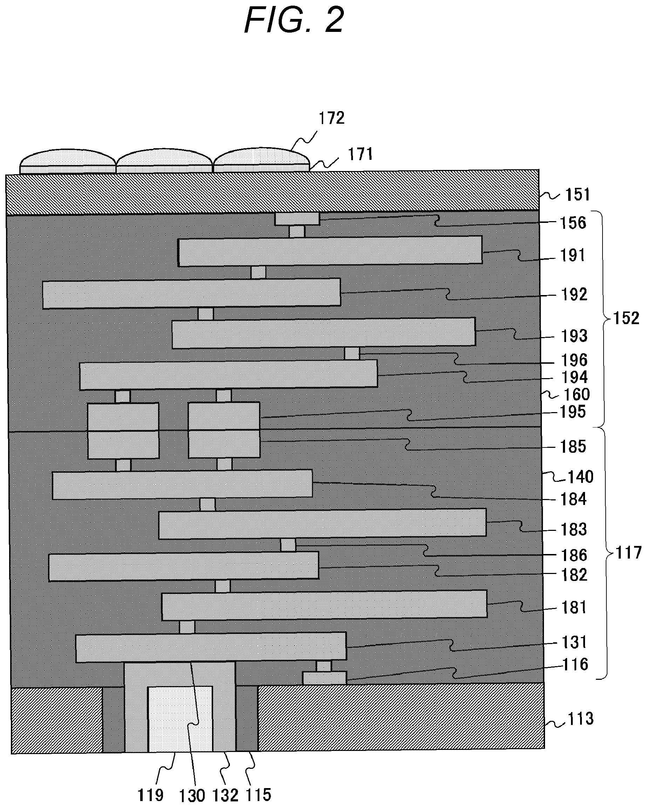

Fig. 1 is a diagram illustrating a configuration example of a semiconductor device according to a first embodiment. Note that a in this drawing is a cross-sectional view illustrating a configuration example of a semiconductor device 100 cut in the vertical direction, and b in this drawing is a back view illustrating a configuration example of the semiconductor device 100. Furthermore, a in this drawing is obtained by performing cutting at a position of A1-A2 in b in this drawing. Fig. 2 is an enlarged cross-sectional view illustrating a specific example of a wiring layer of the semiconductor device according to the first embodiment. Note that, in Fig. 1, wiring layers 117 and 152 are illustrated in a simplified manner, and a specific example of the wiring layers 117 and 152 of Fig. 1 is illustrated in Fig. 2.

In this drawing, the semiconductor device 100 includes semiconductor chips 101 and 102. The semiconductor chip 102 is laminated on the semiconductor chip 101. At this time, the semiconductor chips 101 and 102 can be bonded to each other such that the wiring layers 117 and 152 face each other.

In the semiconductor chip 102, for example, an image sensor in which pixels that perform photoelectric conversion are arranged in a matrix can be formed. The image sensor may be a complementary metal oxide semiconductor (CMOS) image sensor or a charge coupled device (CCD) image sensor. Furthermore, this image sensor may be a back-irradiation image sensor.

In the semiconductor chip 101, for example, a logic circuit that processes a pixel signal output from the pixels formed on the semiconductor chip 102 can be formed. This processing may include, for example, gamma correction, white balance processing, sharpness processing, gradation conversion processing, and the like.

The semiconductor chip 101 includes a semiconductor substrate 111, an intermediate insulating layer 112, and a semiconductor layer 113. The intermediate insulating layer 112 is laminated on the semiconductor substrate 111, and the semiconductor layer 113 is laminated on the intermediate insulating layer 112. As a lamination structure of the semiconductor substrate 111, the intermediate insulating layer 112, and the semiconductor layer 113, for example, an SOI substrate 110 can be used. The material of the semiconductor substrate 111 and the semiconductor layer 113 may be Si, and the material of the intermediate insulating layer 112 may be SiO₂. The material of the semiconductor substrate 111 and the semiconductor layer 113 may be, for example, a compound semiconductor such as GaAs, SiC, or GaN. The thickness of the semiconductor substrate 111 may be about 100 pm, the thickness of the intermediate insulating layer 112 may be about 0.1 um, and the thickness of the semiconductor layer 113 may be about 5 um. Note that the intermediate insulating layer 112 is an example of an insulating layer described in the claims.

A semiconductor element is formed on the semiconductor layer 113. The semiconductor element can include a transistor used for the logic circuit or the like. At this time, a gate electrode 116 can be formed on the semiconductor layer 113 with a gate insulating film interposed therebetween.

Furthermore, an insulating separation layer 115 that insulates and separates a part of the semiconductor layer 113 is formed on the semiconductor layer 113. The insulating separation layer 115 can be formed so as to surround a part of the semiconductor layer 113. The position of the semiconductor layer 113 surrounded by the insulating separation layer 115 can correspond to a formation position of a through electrode 132. An element separation layer that separates semiconductor elements formed on the semiconductor layer 113 from each other may be used as the insulating separation layer 115, or the insulating separation layer 115 may be included separately from an element separation layer that separates semiconductor elements formed on the semiconductor layer 113 from each other. As the insulating separation layer 115, shallow trench isolation (STI) can be used. The insulating separation layer 115 penetrates the semiconductor layer 113 and reaches the intermediate insulating layer 112. At this time, the insulating separation layer 115 may be in contact with the intermediate insulating layer 112, may enter the intermediate insulating layer 112, or may penetrate the intermediate insulating layer 112. As an insulator used for the insulating separation layer 115, for example, SiO₂ can be used. The thickness of the insulating separation layer 115 can be about 0.2 pm.

Furthermore, the wiring layer 117 is formed on the semiconductor layer 113. As illustrated in Fig. 2, a pad electrode 130 and wirings 131 and 181 to 185 are formed in the wiring layer 117. The wirings 131 and 181 to 185 can form multilayer wirings. At this time, the wirings 131 and 181 to 185 can be connected between layers via a via 186. The gate electrode 116, the pad electrode 130, and the wirings 131 and 181 to 185 are embedded in an insulating layer 140. The pad electrode 130 is connected to the wiring 131, and the wiring 131 is connected to the gate electrode 116. The pad electrode 130 can be arranged at a connection position of the through electrode 132. The surface of the uppermost wiring 185 is exposed from the insulating layer 140. The material of the pad electrode 130 and the wirings 131 and 181 to 185 is, for example, Cu.

A back surface insulating film 118 is formed on the back surface side of the semiconductor substrate 111. The material of the back surface insulating film 118 is, for example, SiO₂. The thickness of the back surface insulating film 118 can be about 0.1 um. A back surface wiring 133 is formed on the back surface insulating film 118. The material of the back surface wiring 133 is, for example, Cu.

Furthermore, through holes 121 to 124 are formed in the back surface insulating film 118, the semiconductor substrate 111, the intermediate insulating layer 112, and the semiconductor layer 113, respectively. At this time, in the semiconductor layer 113, the through hole 124 is formed at a position surrounded by the insulating separation layer 115. Furthermore, in the back surface insulating film 118 and the semiconductor substrate 111, a sidewall insulating film 114 is formed on sidewalls in the through holes 121 and 122. The material of the sidewall insulating film 114 is, for example, SiO₂. The thickness of the sidewall insulating film 114 can be about 0.1 um. Note that the sidewall insulating film 114 is an example of an insulating film described in the claims.

In the through holes 121 to 124, a through electrode 132 that penetrates the back surface insulating film 118, the semiconductor substrate 111, the intermediate insulating layer 112, and the semiconductor layer 113 and is connected to the wiring layer 117 is formed. Furthermore, on the back surface side of the semiconductor substrate 111, the through electrode 132 is connected to the back surface wiring 133. Here, in the wiring layer 117, the through electrode 132 can be in contact with the pad electrode 130. Furthermore, the through electrode 132 is surrounded by the intermediate insulating layer 112, the sidewall insulating film 114, and the insulating separation layer 115. At this time, the through electrode 132 is insulated from the semiconductor layer 113 by the intermediate insulating layer 112 and the insulating separation layer 115, and is insulated from the semiconductor substrate 111 by the intermediate insulating layer 112 and the sidewall insulating film 114. The shape of the through electrode 132 can be, for example, a cylindrical shape. The material of the through electrode 132 is, for example, Cu. Here, by using Cu as the material of the through electrode 132 and the back surface wiring 133, the through electrode 132 and the back surface wiring 133 can be formed on the basis of electroplating.

A protective film 119 is formed on the back surface insulating film 118. The protective film 119 covers the back surface wiring 133 and is embedded inside the through electrode 132. The material of the protective film 119 may be, for example, a resin such as a solder resist. An opening 125 is formed in the protective film 119 at a position where the back surface wiring 133 is exposed. A pad electrode 134 is embedded in the opening 125 and connected to the back surface wiring 133. The material of the pad electrode 134 is, for example, Cu. Here, by using Cu as the material of the pad electrode 134, the pad electrode 134 can be embedded in the opening 125 on the basis of electroplating.

The semiconductor chip 102 includes a semiconductor substrate 151 on which a semiconductor element is formed. The semiconductor element can include a photodiode used for a pixel and a pixel transistor that controls reading of a signal from the pixel and the like. At this time, a gate electrode 156 can be formed on the semiconductor layer 151 with a gate insulating film interposed therebetween, as illustrated in Fig. 2. As the material of the semiconductor substrate 151, for example, Si can be used in a case where sensitivity is given to a visible region, and InGaAS can be used in a case where sensitivity is given to an infrared region.

The wiring layer 152 is formed on the semiconductor substrate 151. A wiring 161 is formed in the wiring layer 152. The wiring 161 may be, for example, a multilayer wiring including wirings 191 to 194 as illustrated in Fig. 2. At this time, the wirings 191 to 194 can be connected between layers via a via 196. The gate electrode 156 and the wirings 191 to 194 are embedded in an insulating layer 160. The wiring 191 is connected to the gate electrode 156. The surface of the lowermost layer wiring 195 is exposed from the insulating layer 160. The material of the wirings 181 to 185 is, for example, Cu.

Hybrid bonding between the wiring layers 117 and 152 can be used for bonding the semiconductor chips 101 and 102. In this hybrid bonding, the wirings 185 and 195 are formed at positions facing each other. Furthermore, the wirings 185 and 195 are recessed by about several tens nm from the surfaces of the insulating layers 140 and 160, respectively. Then, after surface processing of the insulating layers 140 and 160 is performed, the insulating layers 140 and 160 are brought into facing contact with each other, so that the insulating layers 140 and 160 are connected to each other. At this time, a slight gap is formed between the wirings 185 and 195. Then, by heat processing being performed in a state where the insulating layers 140 and 160 are pressure-bonded to each other, the wirings 185 and 195 expand to bring the wirings 185 and 195 into contact with each other, and Cu interdiffuses with each other, thereby forming bonding between the wirings 185 and 195.

On the back surface side of the semiconductor substrate 151, a color filter 171 is formed for each of the pixels. The color filter 171 can form, for example, a Bayer array. An on-chip lens 172 is formed on the color filter 171 for each of the pixels.

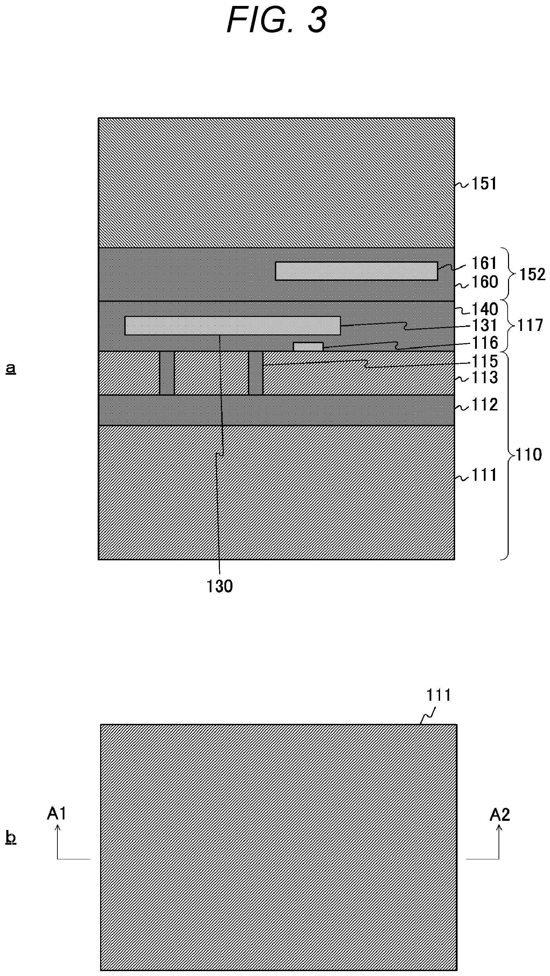

Figs. 3 to 7 are diagrams illustrating an example of a method for manufacturing the semiconductor device according to the first embodiment. Note that a in Figs. 3 to 7 is a cross-sectional view cut at the same position as a in Fig. 1, and b in Figs. 3 to 7 is a view seen from the back surface side of the SOI substrate in each step of a in Figs. 3 to 7.

As illustrated in Fig. 3, the insulating separation layer 115 is formed on the semiconductor layer 113 of the SOI substrate 110, and a semiconductor element such as a transistor is formed on the semiconductor layer 113. Then, the wiring layer 117 is formed on the semiconductor layer 113. Furthermore, a semiconductor element such as a solid-state imaging element is formed on the semiconductor substrate 151, and the wiring layer 152 is formed on the semiconductor substrate 151. Then, the wiring layers 117 and 152 are bonded to each other by a method such as hybrid bonding.

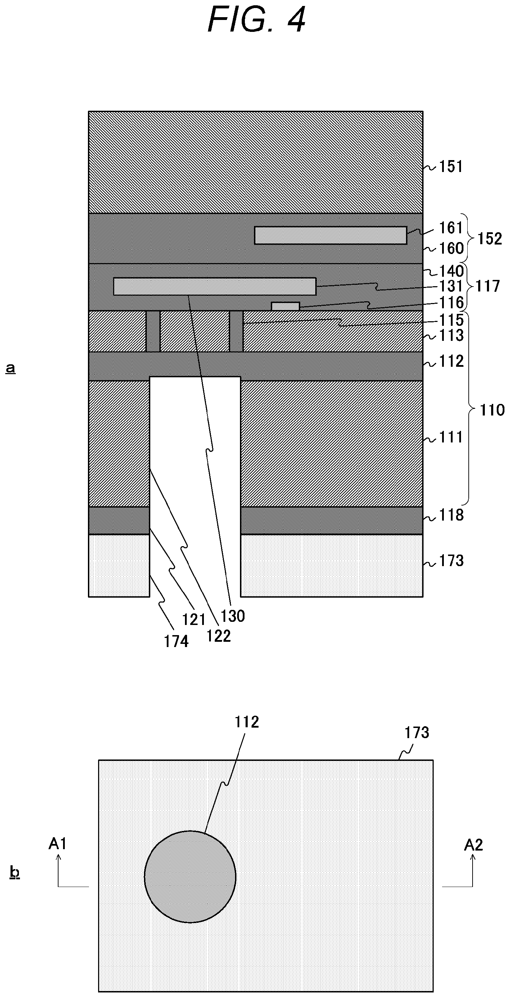

Next, as illustrated in Fig. 4, the back surface insulating film 118 is formed on the back surface side of the semiconductor substrate 111 by chemical vapor deposition (CVD). Moreover, a resist pattern 173 that includes an opening 174 is formed on the back surface insulating film 118 by a photolithography technique. The opening 174 can be arranged at the position of the pad electrode 130 when viewed from the back surface side of the SOI substrate 110. Then, the back surface insulating film 118 and the semiconductor substrate 111 are etched using the resist pattern 173 as an etching mask to form the through holes 121 and 122 in the back surface insulating film 118 and the semiconductor substrate 111, respectively. Note that anisotropic etching such as reactive ion etching (RIE) can be used for forming the through holes 121 and 122. Here, the intermediate insulating layer 112 can be used as an etch stopper during etching the semiconductor substrate 111. Note that the intermediate insulating layer 112 may be over-etched.

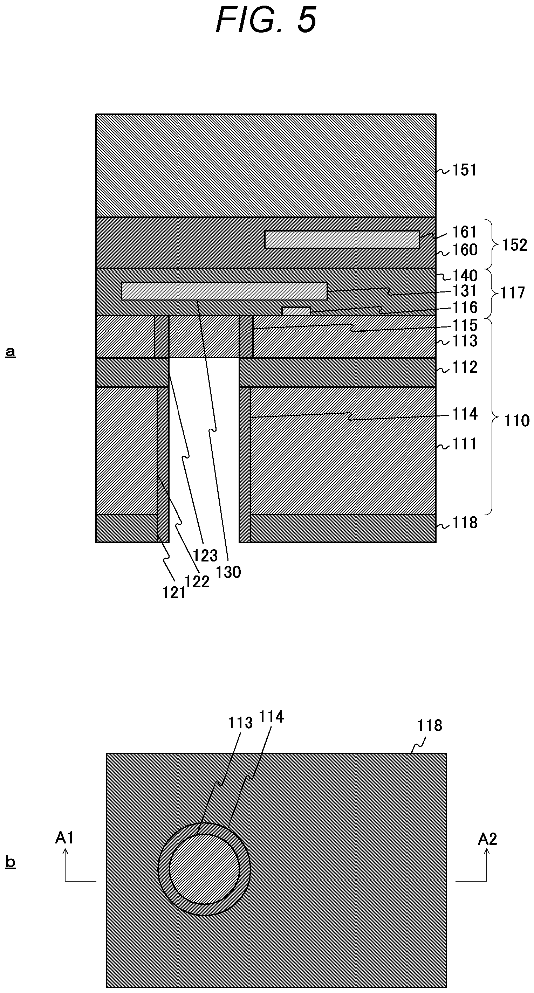

Next, as illustrated in Fig. 5, the resist pattern 173 is removed. Then, the sidewall insulating film 114 is formed by CVD, and the sidewall insulating film 114 on the back surface insulating film 118 is removed by etchback. Then, the intermediate insulating layer 112 is etched using the back surface insulating film 118 in which the through hole 121 is formed and the sidewall insulating film 114 as etching masks, thereby forming the through hole 123 in the intermediate insulating layer 112. Note that anisotropic etching such as RIE can be used for forming the through hole 123. Here, the semiconductor layer 113 can be used as an etch stopper during etching the intermediate insulating layer 112. Note that the semiconductor layer 113 may be over-etched. Furthermore, in a case where the material of the intermediate insulating layer 112 and the back surface insulating film 118 is SiO₂ and the back surface insulating film 118 is used as an etching mask for etching the intermediate insulating layer 112, the film thickness of the back surface insulating film 118 is made thicker than the film thickness of the intermediate insulating layer 112.

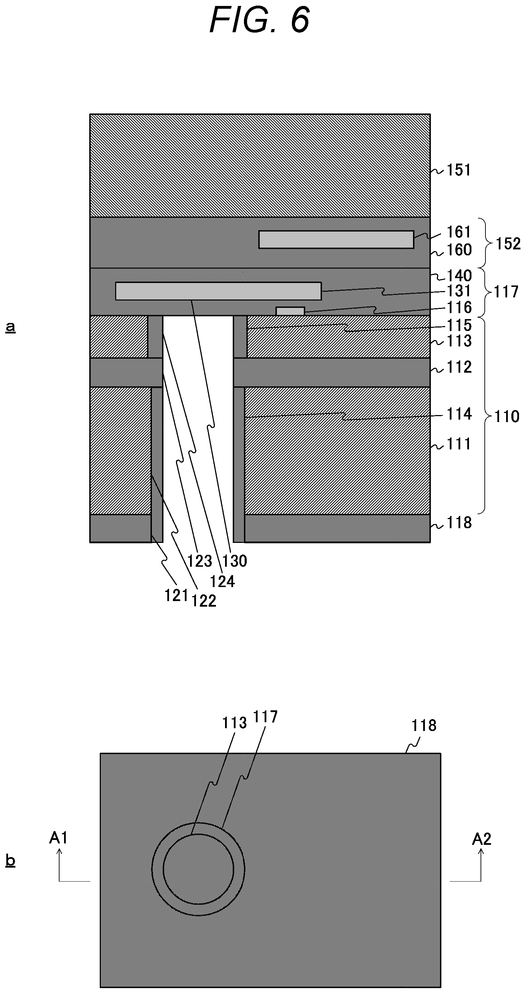

Next, as illustrated in Fig. 6, the semiconductor layer 113 is etched using the intermediate insulating layer 112 in which the through hole 123 is formed as an etching mask, thereby forming the through hole 124 in the semiconductor layer 113. Note that isotropic etching can be used for forming the through hole 124. The isotropic etching may be, for example, wet etching using a KOH solution as an etching solution, or chemical dry etching using XeF₂, CF₄, NF₃, CH₂F₂, or the like as an etching gas. Here, the inner periphery of the through hole 124 can be covered with the insulating separation layer 115. At this time, the insulating separation layer 115 and the wiring layer 117 can be used as etch stoppers.

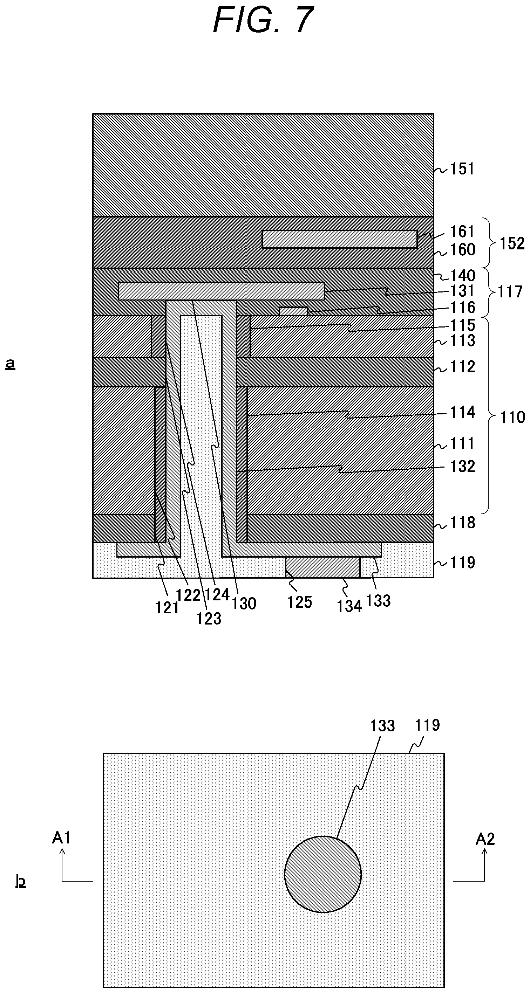

Next, as illustrated in Fig. 7, the insulating layer 140 on the back surface side of the pad electrode 130 is etched through the through holes 121 to 124 to expose the back surface of the pad electrode 130. Note that anisotropic etching such as RIE can be used for etching the insulating layer 140. Then, the through electrode 132 connected to the pad electrode 130 is formed in the through holes 121 to 124, and the back surface wiring 133 is formed on the back surface insulating film 118. A plating layer can be used for the through electrode 132 and the back surface wiring 133. In a case where a plating layer is formed by electroplating, a seed layer can be formed on the entire surface before the electroplating, and the plating layer can be formed on the seed layer. Then, the through electrode 132 and the back surface wiring 133 can be formed by patterning the seed layer and the plating layer using a photolithography technique and an etching technique.

As the material of the seed layer, for example, Cu can be used. For forming the seed layer, for example, CVD using a monovalent Cu β-diketone complex and a reducing agent that reduces the monovalent Cu β-diketone complex as raw materials can be used. The seed layer may be formed by atomic layer deposition (ALD) CVD. A Cu seed layer may be done by a sputtering method.

Next, the protective film 119 is formed on the back surface insulating film 118 so as to be embedded inside the through electrode 132 by a method such as coating. Then, the opening 125 is formed in the protective film 119 by patterning the protective film 119 using the photolithography technique and the etching technique. Then, the pad electrode 134 connected to the back surface wiring 133 is formed in the opening 125. Electroplating can be used for forming the pad electrode 134, for example. In a case where the pad electrode 134 is formed by electroplating, a seed layer can be formed on the entire surface before the electroplating, and a plating layer can be formed on the seed layer. Then, by the seed layer and the plating layer on the protective film 119 being removed by CMP, the pad electrode 134 can be embedded in the opening 125.

Next, as illustrated in Fig. 1, the semiconductor substrate 151 is thinned from the surface on the back surface side by a method such as CMP. Then, the color filter 171 is formed on the surface on the surface on the back surface side of the semiconductor substrate 151, and the on-chip lens 172 is formed on the color filter 171. The surface on the back surface side of the semiconductor substrate 151 here is a surface opposite to the surface on which the wiring layer 152 is formed.

As described above, in the above-described first embodiment, the through electrode 132 that penetrates the semiconductor substrate 111, the intermediate insulating layer 112, and the semiconductor layer 113 and is surrounded by the sidewall insulating film 114, the intermediate insulating layer 112, and the insulating separation layer 115 is included in the semiconductor chip 101. With this arrangement, the intermediate insulating layer 112 can be used as an etch stopper during forming the through hole 122, and over-etching of the wiring layer 117 can be reduced even in a case where the semiconductor substrate 111 is thickened. As a result, while the mechanical strength of the semiconductor chip 101 is maintained, plasma induced damage (PID) caused by dry etching for opening the wiring layer 117 can be reduced, and characteristic fluctuation of a transistor electrically connected to the wiring layer 117 can be reduced.

Furthermore, according to the above-described first embodiment, the through electrode 132 is surrounded by the insulating separation layer 115. As a result, while side etching of the semiconductor layer 113 is reduced, the through hole 124 can be formed in the semiconductor layer 113 by isotropic etching, and damage during forming the through hole 124 can reduced.

Furthermore, according to the above-described first embodiment, by the through electrode 132 being formed on the SOI substrate 110, the wiring can be drawn out from the back surface side of the semiconductor chip 101. Therefore, the wiring does not need to be drawn out from the front surface side of the semiconductor chip 101, and the chip size of the semiconductor chip 101 can be reduced.

Furthermore, according to the above-described first embodiment, by using Si as the material of the semiconductor layer 113 and the semiconductor substrate 111, a selection ratio of etching of the intermediate insulating layer 112 with respect to the semiconductor layer 113 and the semiconductor substrate 111 can be secured. Therefore, the intermediate insulating layer 112 can be used as an etch stopper in a case where the through hole 122 is formed in the semiconductor substrate 111, and erosion of the insulating separation layer 115 and the intermediate insulating layer 112 in a case where the through hole 124 is formed on the semiconductor layer 113 can be reduced.

Furthermore, according to the above-described first embodiment, by using SiO₂ as the material of the intermediate insulating layer 112, the intermediate insulating layer 112 can be used as an etch stopper in a case where the through hole 122 is formed in the semiconductor substrate 111.

Furthermore, in the above-described first embodiment, an image sensor is formed on the semiconductor chip 102, and a logic circuit that processes a pixel signal output from the image sensor is formed on the semiconductor chip 101. As a result, the semiconductor device 100 to which an image sensor function is added can be formed without the area of the semiconductor chip 101 increased.

### <2. Second Embodiment>

In the above-described first embodiment, the through electrode 132 that penetrates the semiconductor substrate 111, the intermediate insulating layer 112, and the semiconductor layer 113 and is surrounded by the sidewall insulating film 114, the intermediate insulating layer 112, and the insulating separation layer 115 has been included in the semiconductor chip 101. In this second embodiment, in addition to a through electrode that penetrates a semiconductor substrate, an intermediate insulating layer, and a semiconductor layer, an embedded wiring embedded in the semiconductor layer is included in a semiconductor chip.

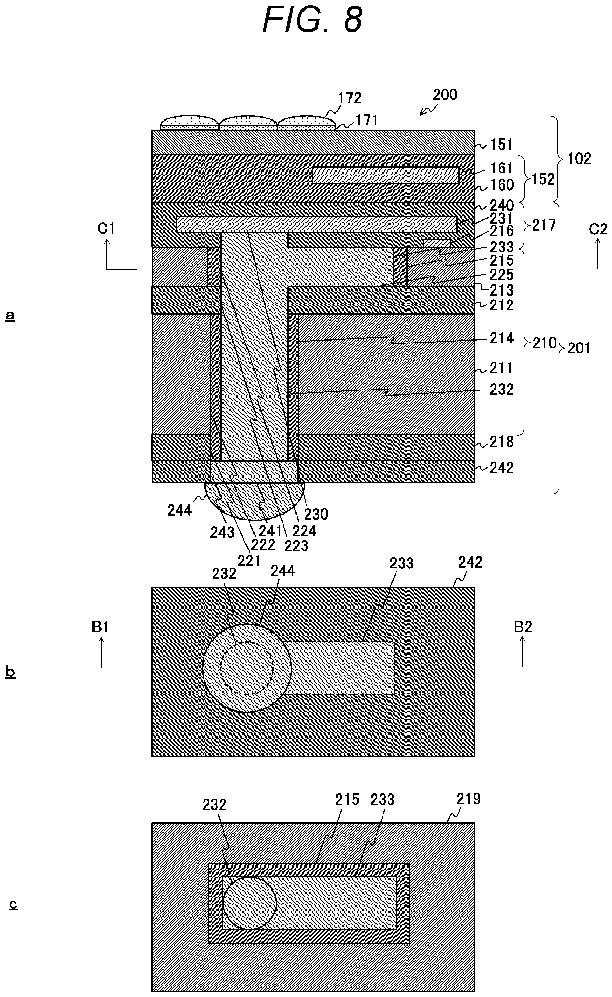

Fig. 8 is a diagram illustrating a configuration example of a semiconductor device according to the second embodiment. Note that a in this drawing is a cross-sectional view illustrating a configuration example of a semiconductor device 200 cut in the vertical direction, b in this drawing is a back view illustrating a configuration example of the semiconductor device 200, and c in this drawing is a cross-sectional view illustrating a configuration example of the semiconductor device 200 cut in the horizontal direction, a in this drawing is obtained by performing cutting at a position of B1-B2 in b in this drawing, c in this drawing is obtained by performing cutting at a position of C1-C2 in a in this drawing.

In this drawing, the semiconductor device 200 includes a semiconductor chip 201 instead of the semiconductor chip 101 of the above-described first embodiment. Other configurations of the semiconductor device 200 of the second embodiment are similar to those of the semiconductor device 100 of the above-described first embodiment.

The semiconductor chip 101 includes a semiconductor substrate 211, an intermediate insulating layer 212, and a semiconductor layer 213. The intermediate insulating layer 212 is laminated on the semiconductor substrate 211, and the semiconductor layer 213 is laminated on the intermediate insulating layer 212. As a lamination structure of the semiconductor substrate 211, the intermediate insulating layer 212, and the semiconductor layer 213, for example, an SOI substrate 210 can be used.

A semiconductor element such as a transistor is formed on the semiconductor layer 213. At this time, a gate electrode 216 can be formed on the semiconductor layer 213 with a gate insulating film interposed therebetween.

Furthermore, an insulating separation layer 215 that insulates and separates a part of the semiconductor layer 213 is formed on the semiconductor layer 213. The insulating separation layer 215 can be formed so as to surround a part of the semiconductor layer 213. The position of the semiconductor layer 213 surrounded by the insulating separation layer 215 can correspond to formation positions of a through electrode 232 and an embedded wiring 233. As the insulating separation layer 215, STI can be used. The insulating separation layer 215 penetrates the semiconductor layer 213 and reaches the intermediate insulating layer 212.

Furthermore, a wiring layer 217 is formed on the semiconductor layer 213. A pad electrode 230 and a wiring 231 are formed in the wiring layer 217. The pad electrode 230 and the wiring 231 are embedded in an insulating layer 240. The pad electrode 230 is connected to the wiring 231. A back surface insulating film 218 is formed on the back surface side of the semiconductor substrate 211.

Furthermore, through holes 221 to 224 are formed in the back surface insulating film 218, the semiconductor substrate 211, the intermediate insulating layer 212, and the semiconductor layer 213, respectively. Furthermore, a cavity 225 that communicates with the through hole 224 is formed in the semiconductor layer 213. At this time, in the semiconductor layer 213, the through hole 224 and the cavity 225 are formed at a position surrounded by the insulating separation layer 215. Furthermore, in the back surface insulating film 218 and the semiconductor substrate 211, a sidewall insulating film 214 is formed on sidewalls in the through holes 221 and 222.

In the through holes 221 to 224, a through electrode 232 that penetrates the back surface insulating film 218, the semiconductor substrate 211, the intermediate insulating layer 212, and the semiconductor layer 213 and is connected to the wiring layer 217 is formed. Here, in the wiring layer 217, the through electrode 232 can be in contact with the pad electrode 230. Furthermore, the embedded wiring 233 connected to the through electrode 232 is formed in the cavity 225. In the semiconductor substrate 211, the through electrode 232 is surrounded by the sidewall insulating film 214. Furthermore, in the semiconductor layer 213, the through electrode 232 and the embedded wiring 233 are surrounded by the insulating separation layer 215. At this time, the through electrode 232 is insulated from the semiconductor layer 213 by the intermediate insulating layer 212 and the insulating separation layer 215, and is insulated from the semiconductor substrate 211 by the intermediate insulating layer 212 and the sidewall insulating film 214. Furthermore, the embedded wiring 233 is insulated from the semiconductor layer 213 by the insulating separation layer 215 and is insulated from the semiconductor substrate 211 by the intermediate insulating layer 212. Note that the embedded wiring 233 may be used as a power supply line or a signal line. The material of the through electrode 232 and the embedded wiring 233 is, for example, Cu. Here, by using Cu as the material of the through electrode 232 and the embedded wiring 233, the through electrode 232 and the embedded wiring 233 can be formed on the basis of electroplating.

A protective film 242 is formed on the back surface insulating film 218. The material of the protective film 242 may be, for example, SiO₂ or SiN. An opening 243 is formed in the protective film 242 at a position where the through electrode 232 is exposed. A pad electrode 241 is embedded in the opening 243 and connected to the through electrode 232. A projecting electrode 244 is formed on the pad electrode 241. The projecting electrode 244 may be a bump electrode or a pillar electrode. The material of the projecting electrode 244 and the pad electrode 241 is, for example, Cu. Here, by using Cu as the material of the projecting electrode 244 and the pad electrode 241, the projecting electrode 244 and the pad electrode 241 can be formed on the basis of electroplating.

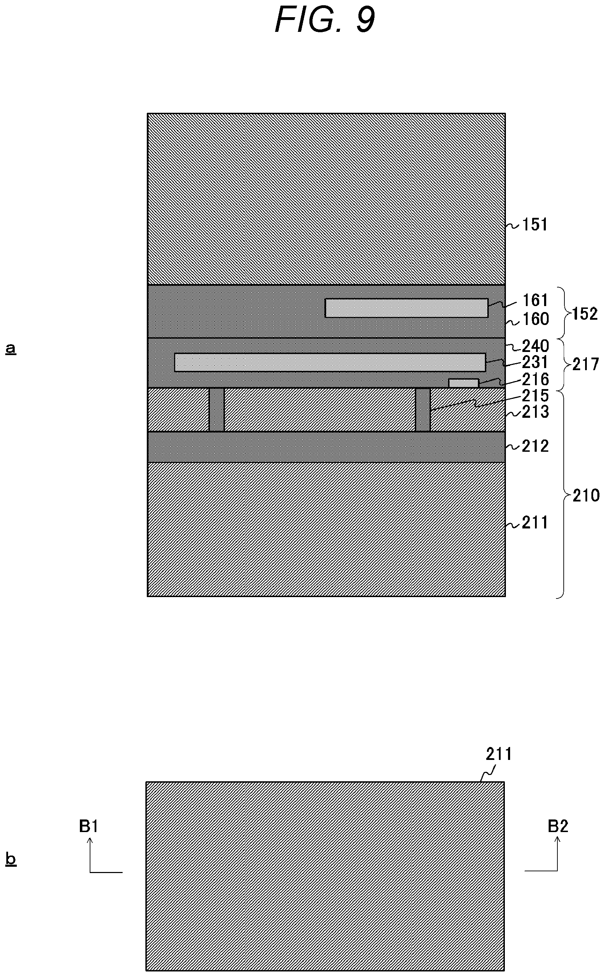

Figs. 9 to 15 are diagrams illustrating an example of a method for manufacturing the semiconductor device according to the second embodiment. Note that a in Figs. 9 to 15 is a cross-sectional view cut at the same position as a in Fig. 8, and b in Figs. 9 to 15 is a view seen from the back surface side of the SOI substrate in each step of a in Figs. 9 to 15.

As illustrated in Fig. 9, the insulating separation layer 215 is formed on the semiconductor layer 213 of the SOI substrate 210, and a semiconductor element such as a transistor is formed on the semiconductor layer 213. Then, the wiring layer 217 is formed on the semiconductor layer 213, and the wiring layer 217 is bonded to the wiring layer 152 by a method such as hybrid bonding.

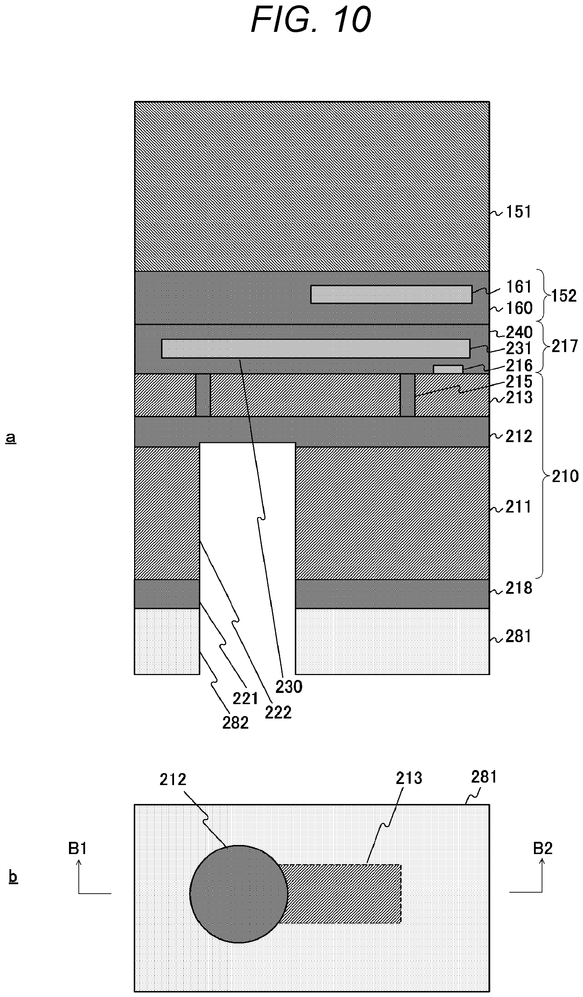

Next, as illustrated in Fig. 10, the back surface insulating film 218 is formed on the back surface side of the semiconductor substrate 211 by CVD. Moreover, a resist pattern 281 that includes an opening 282 is formed on the back surface insulating film 218 by a photolithography technique. The opening 282 can be arranged at the position of the pad electrode 230 when viewed from the back surface side of the SOI substrate 210. Then, the back surface insulating film 218 and the semiconductor substrate 211 are etched using the resist pattern 281 as an etching mask to form the through holes 221 and 222 in the back surface insulating film 218 and the semiconductor substrate 211, respectively.

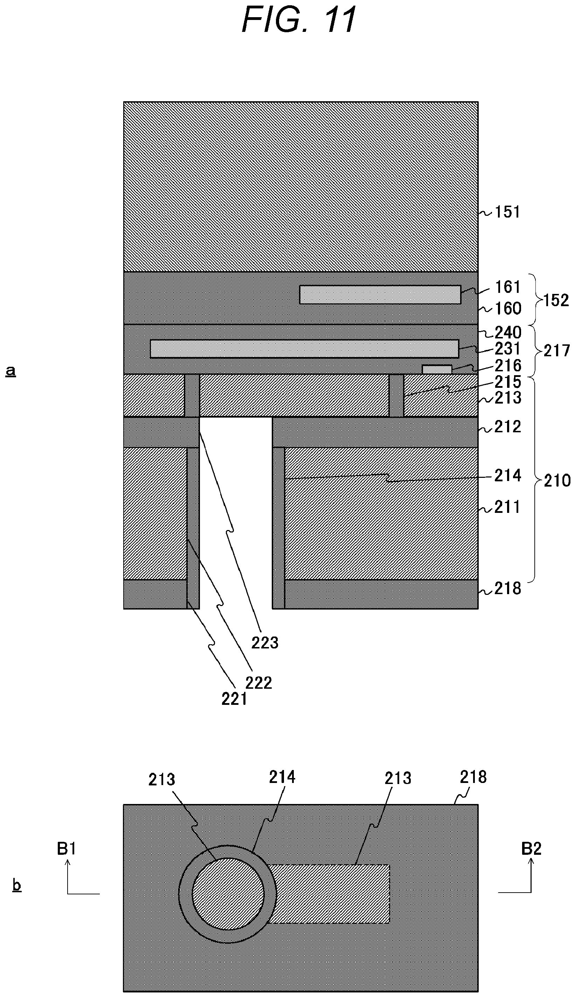

Next, as illustrated in Fig. 11, the resist pattern 281 is removed. Then, the sidewall insulating film 214 is formed by CVD, and the sidewall insulating film 214 on the back surface insulating film 218 is removed by etchback. Then, the intermediate insulating layer 212 is etched using the back surface insulating film 218 in which the through hole 221 is formed and the sidewall insulating film 214 as etching masks, thereby forming the through hole 223 in the intermediate insulating layer 212.

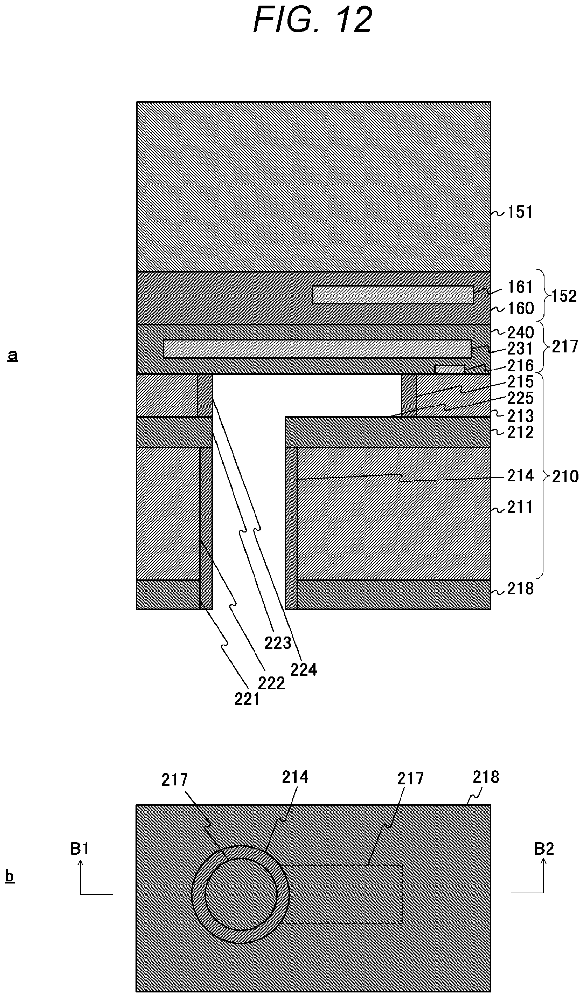

Next, as illustrated in Fig. 12, the semiconductor layer 213 is etched using the intermediate insulating layer 212 in which the through hole 223 is formed as an etching mask, thereby forming the through hole 224 and the cavity 225 in the semiconductor layer 213. Note that isotropic etching can be used for forming the through hole 224 and the cavity 225. Here, by using isotropic etching, the semiconductor layer 213 can be etched in the horizontal direction through the through hole 224, and the cavity 225 that communicates with the through hole 224 can be formed in the semiconductor layer 213. At this time, the insulating separation layer 215 and the insulating layer 240 can be used as etch stoppers.

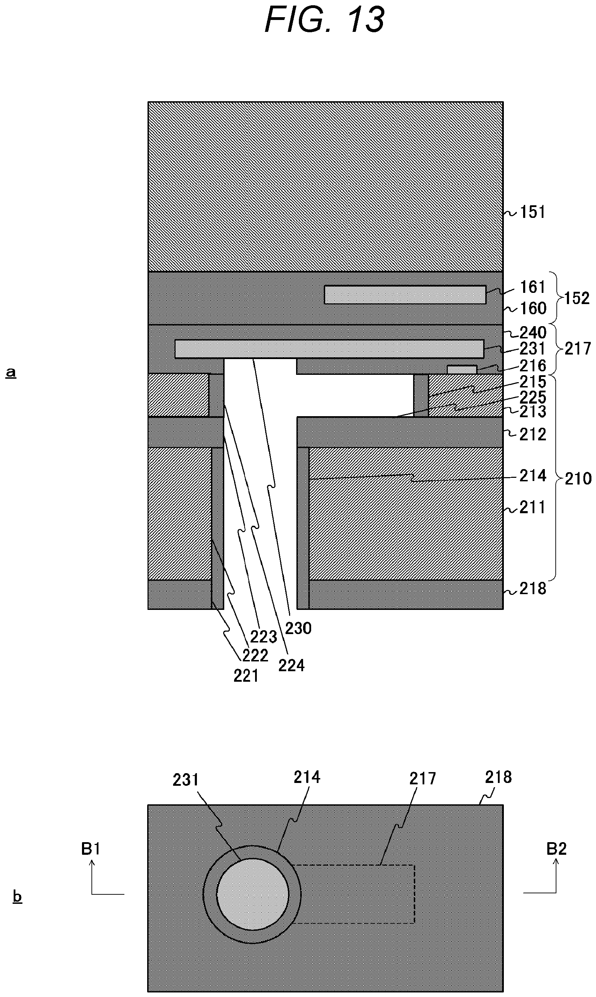

Next, as illustrated in Fig. 13, the insulating layer 240 on the back surface side of the pad electrode 230 is etched through the through holes 221 to 224 to expose the back surface side of the pad electrode 230.

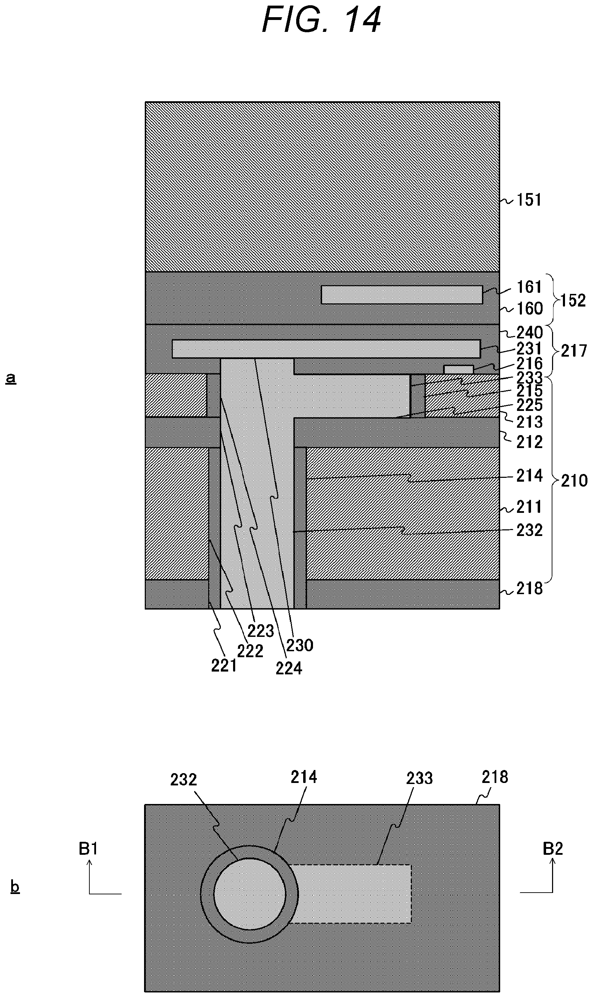

Next, as illustrated in Fig. 14, the through electrode 232 connected to the pad electrode 230 is formed in the through holes 221 to 224, and the embedded wiring 233 connected to the through electrode 232 is formed in the cavity 225. A plating layer can be used for the through electrode 232 and the embedded wiring 233. For forming a seed layer used for forming the plating layer, CVD using a monovalent Cu β-diketone complex and a reducing agent that reduces the monovalent Cu β-diketone complex as raw materials may be used, or ALD CVD may be used. Then, the through electrode 232 is planarized by CMP to expose the back surface insulating film 218.

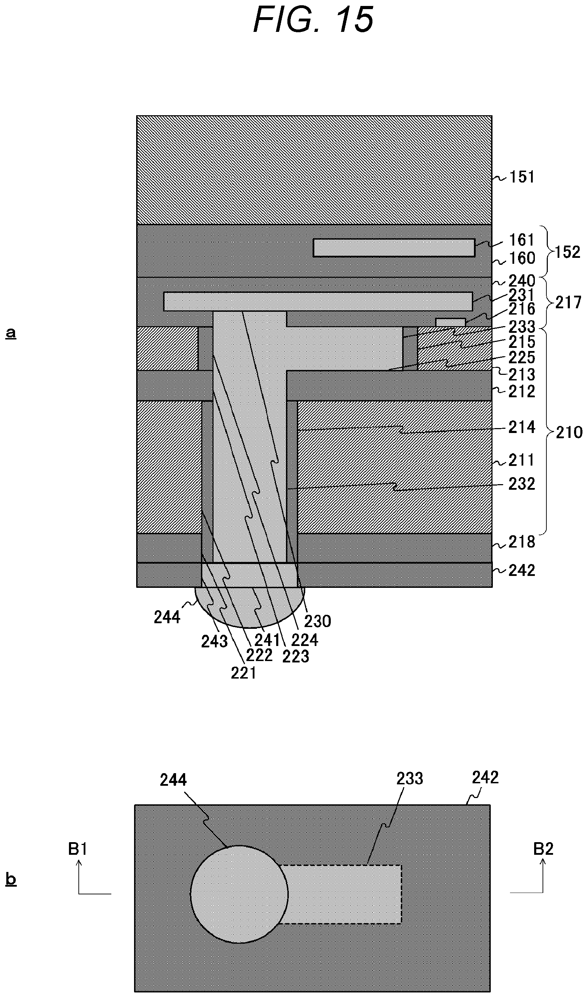

Next, as illustrated in Fig. 15, the protective film 242 is formed on the back surface insulating film 218 by a method such as CVD or sputtering. Then, the opening 243 is formed by patterning the protective film 242 using the photolithography technique and the etching technique. Then, a plating layer is formed so that the opening 243 is filled, and the plating layer is thinned by CMP to expose the surface of the protective film 242 and form the pad electrode 241 embedded in the opening 243. Then, the projecting electrode 244 is formed on the pad electrode 241 by a method such as electroplating. At this time, since the pad electrode 241 is included below the projecting electrode 244, formation of a seed layer for performing electroplating may be omitted.

Next, as illustrated in Fig. 8, a semiconductor substrate 151 is thinned from the back surface side by a method such as CMP. Then, a color filter 171 is formed on the back surface side of the semiconductor substrate 151, and an on-chip lens 172 is formed on the color filter 171.

As described above, in the above-described second embodiment, in addition to the through electrode 232 that penetrates the semiconductor substrate 211, the intermediate insulating layer 212, and the semiconductor layer 213, the embedded wiring 233 surrounded by the insulating separation layer 215 is embedded in the semiconductor layer 213. As a result, a wiring region can be enlarged without the area of the semiconductor layer 213 on which a semiconductor element is formed increased, and the stability of power feeding can be improved.

Furthermore, according to the above-described second embodiment, the through hole 224 in which the through electrode 232 is embedded and the cavity 225 in which the embedded wiring 233 is embedded can be collectively formed in the semiconductor layer 213, and the through electrode 232 and the embedded wiring 233 can be collectively embedded in the semiconductor layer 213. Therefore, a step of forming the through electrode 232 and a step of forming the embedded wiring 233 do not need to be separately provided, and an increase in the number of steps during forming the through electrode 232 and the embedded wiring 233 can be reduced.

### <3. Third Embodiment>

In the above-described second embodiment, the projecting electrode 244 has been included at the position of the through electrode 232 on the back surface side of the SOI substrate. In this third embodiment, a projecting electrode is included at a position away from a through electrode 232 on the back surface side of an SOI substrate, and the through electrode 232 and the projecting electrode are connected via a back surface wiring.

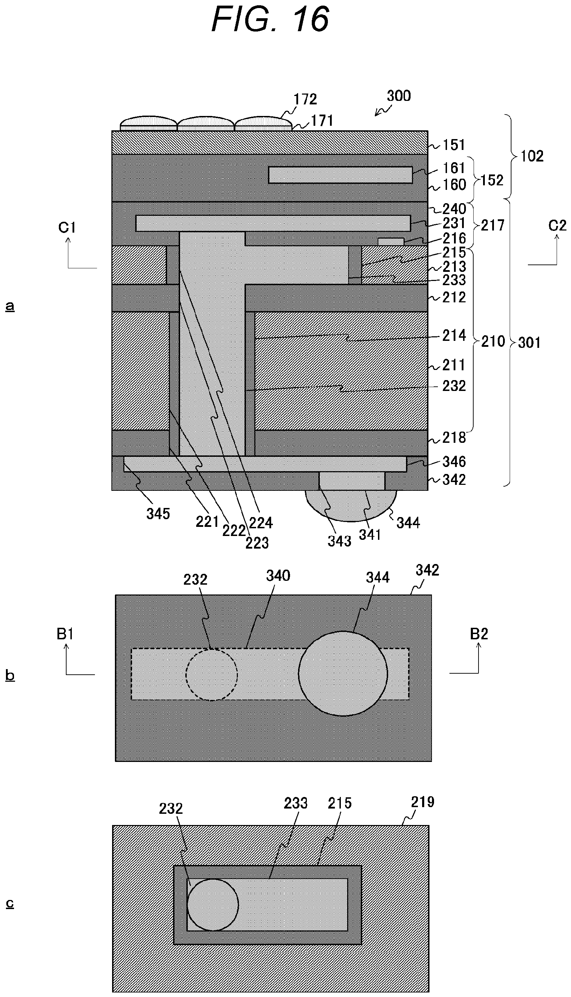

Fig. 16 is a diagram illustrating a configuration example of a semiconductor device according to the third embodiment. Note that a in this drawing is a cross-sectional view illustrating a configuration example of a semiconductor device 300 cut in the vertical direction, b in this drawing is a back view illustrating a configuration example of the semiconductor device 300, and c in this drawing is a cross-sectional view illustrating a configuration example of the semiconductor device 300 cut in the horizontal direction, a in this drawing is obtained by performing cutting at a position of B1-B2 in b in this drawing, c in this drawing is obtained by performing cutting at a position of C1-C2 in a in this drawing.

In this drawing, the semiconductor device 300 includes a semiconductor chip 301 instead of the semiconductor chip 201 of the above-described second embodiment. Other configurations of the semiconductor device 300 of the third embodiment are similar to those of the semiconductor device 200 of the above-described second embodiment.

The semiconductor chip 301 includes a pad electrode 341, a protective film 342, a projecting electrode 344, and a back surface wiring 346 instead of the pad electrode 241, the protective film 242, and the projecting electrode 244 of the above-described second embodiment. Other configurations of the semiconductor chip 301 of the third embodiment are similar to those of the semiconductor chip 201 of the above-described second embodiment.

A protective film 342 is formed on a back surface insulating film 218. A wiring groove 345 and an opening 343 are formed in the protective film 342. The wiring groove 345 is formed at a position where the through electrode 232 is exposed. The opening 343 is formed at a position away from the through electrode 232 in the horizontal direction of the semiconductor chip 301. The back surface wiring 346 is embedded in the wiring groove 345 and connected to the through electrode 232. A pad electrode 341 is embedded in the opening 343 and connected to the back surface wiring 346. A projecting electrode 344 is formed on the pad electrode 341. The projecting electrode 344 may be a bump electrode or a pillar electrode. The material of the projecting electrode 344, the pad electrode 341, and the back surface wiring 346 is, for example, Cu. Here, by using Cu as the material of the projecting electrode 344, the pad electrode 341, and the back surface wiring 346, the projecting electrode 344, the pad electrode 341, and the back surface wiring 346 can be formed on the basis of electroplating.

As described above, in the above-described third embodiment, the through electrode 232 and the projecting electrode 344 are connected via the back surface wiring 346. As a result, the projecting electrode 344 does not need to be included at the position of the through electrode 232 on the back surface side of an SOI substrate 210, and the flexibility in arrangement of the through electrode 232 and the projecting electrode 344 can be improved.

### <4. Fourth Embodiment>

In the above-described second embodiment, in addition to the through electrode 232 that penetrates the semiconductor substrate 211, the intermediate insulating layer 212, and the semiconductor layer 213, the embedded wiring 233 embedded in the semiconductor layer 213 has been included in the semiconductor chip 201. In this fourth embodiment, an embedded wiring embedded in a semiconductor layer 213 has a straight single structure.

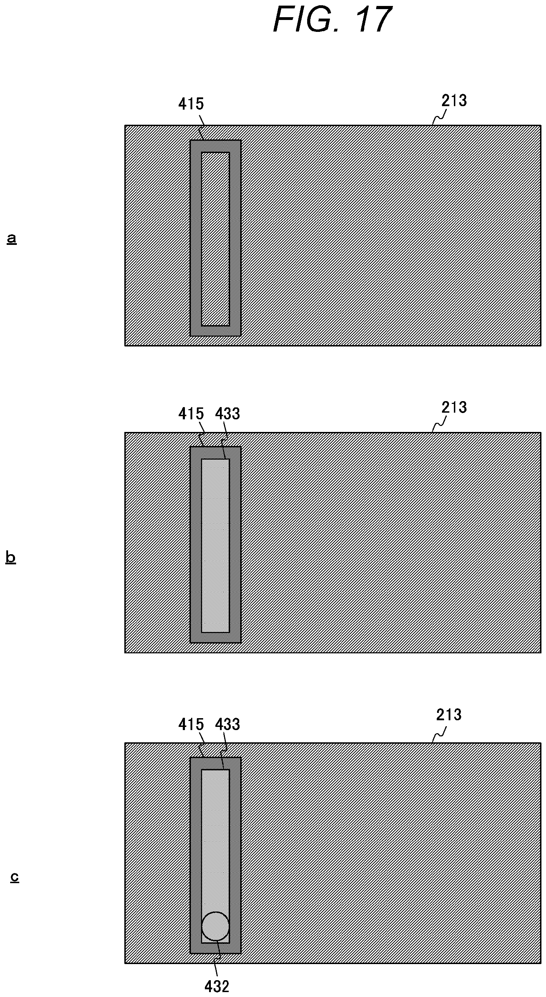

Fig. 17 is a diagram illustrating a configuration example of a semiconductor device according to the fourth embodiment. Note that a in this drawing is a cross-sectional view illustrating a configuration example of the semiconductor layer 213 after formation of an insulating separation layer 415 cut in the horizontal direction, b in this drawing is a cross-sectional view illustrating a configuration example of the semiconductor layer 213 after formation of an embedded wiring 433 cut in the horizontal direction. c in this drawing is a cross-sectional view illustrating an arrangement example of a through electrode 432 in b in this drawing.

In this drawing, the insulating separation layer 415 and the embedded wiring 433 are formed in the semiconductor layer 213. The insulating separation layer 415 can separate the semiconductor layer 213 into the inward side and the outward side. The embedded wiring 433 is surrounded by the insulating separation layer 415. Here, by the semiconductor layer 213 inside the insulating separation layer 415 being removed, the embedded wiring 433 can be embedded in the semiconductor layer 213. The through electrode 432 is connected to the embedded wiring 433. The through electrode 432 can be arranged at a position surrounded by the insulating separation layer 415.

As described above, according to the above-described fourth embodiment, the embedded wiring 433 embedded in the semiconductor layer 213 has a single structure, thereby locally improving the stability of power supply.

### <5. Fifth Embodiment>

In the above-described fourth embodiment, the embedded wiring 433 embedded in the semiconductor layer 213 has had a single structure. In this fifth embodiment, embedded wirings 433 embedded in a semiconductor layer 213 have a multi-structure.

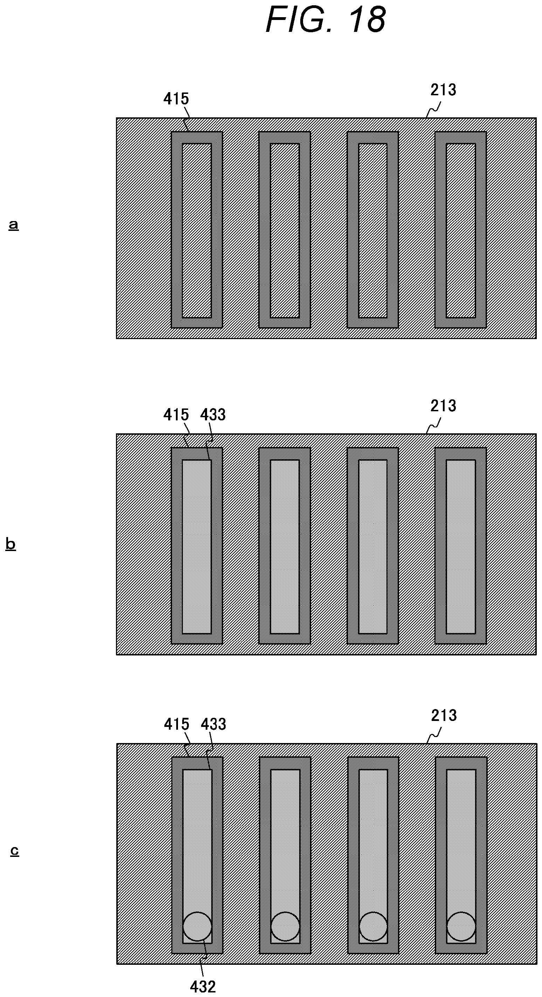

Fig. 18 is a diagram illustrating a configuration example of a semiconductor device according to the fifth embodiment. Note that a in this drawing is a cross-sectional view illustrating a configuration example of the semiconductor layer 213 after formation of insulating separation layers 415 cut in the horizontal direction, b in this drawing is a cross-sectional view illustrating a configuration example of the semiconductor layer 213 after formation of the embedded wirings 433 cut in the horizontal direction. c in this drawing is a cross-sectional view illustrating an arrangement example of through electrodes 432 in b in this drawing.

In this drawing, the insulating separation layers 415 and the embedded wirings 433 are formed in the semiconductor layer 213. Here, a plurality of insulating separation layers 415 is included in a state of being separated from each other. Each of the insulating separation layers 415 can separate the semiconductor layer 213 into the inward side and the outward side. The embedded wirings 433 are formed at positions surrounded by the respective insulating separation layers 415. In this drawing, an example in which only four embedded wirings 433 are included in the semiconductor layer 213 is illustrated. Here, by the semiconductor layer 213 inside each of the insulating separation layers 415 being removed, each of the embedded wirings 433 can be embedded in the semiconductor layer 213. The through electrodes 432 are connected to the respective embedded wirings 433. The through electrodes 432 can be arranged at positions surrounded by the respective insulating separation layers 415.

As described above, according to the above-described fifth embodiment, the embedded wirings 433 embedded in the semiconductor layer 213 have a multi-structure, thereby improving the stability of power supply while making the supply voltages different from each other.

### <6. Sixth Embodiment>

In the above-described fourth embodiment, the embedded wiring 433 embedded in the semiconductor layer 213 has had a straight single structure. In this sixth embodiment, an embedded wiring embedded in a semiconductor layer 213 has a folded structure.

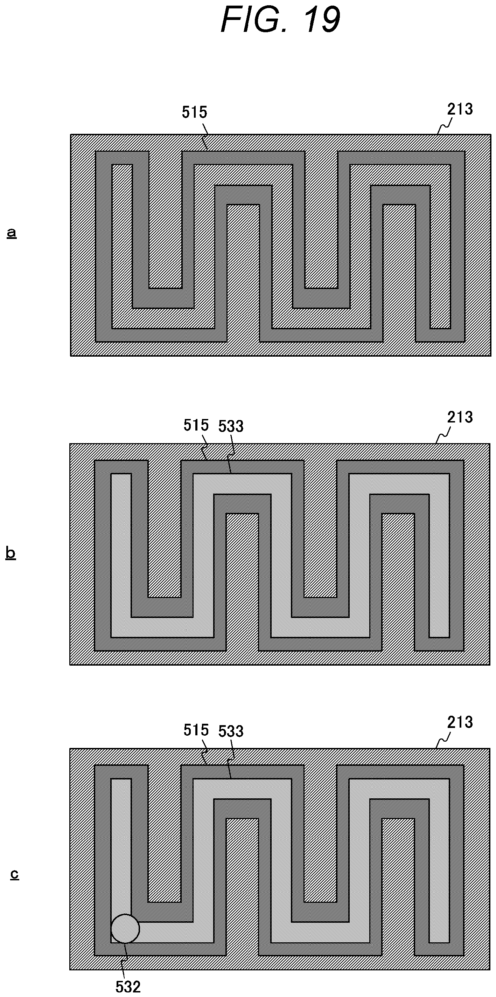

Fig. 19 is a diagram illustrating a configuration example of a semiconductor device according to the sixth embodiment. Note that a in this drawing is a cross-sectional view illustrating a configuration example of the semiconductor layer 213 after formation of an insulating separation layer 515 cut in the horizontal direction, b in this drawing is a cross-sectional view illustrating a configuration example of the semiconductor layer 213 after formation of an embedded wiring 533 cut in the horizontal direction. c in this drawing is a cross-sectional view illustrating an arrangement example of a through electrode 532 in b in this drawing.

In this drawing, the insulating separation layer 515 and the embedded wiring 533 are formed in the semiconductor layer 213. The insulating separation layer 515 can have a folded structure while separating the semiconductor layer 213 into the inward side and the outward side. The embedded wiring 533 is surrounded by the insulating separation layer 515. Here, by the semiconductor layer 213 inside the insulating separation layer 515 being removed, the embedded wiring 533 can be embedded in the semiconductor layer 213 in a rectangular wave shape. The through electrode 532 is connected to the embedded wiring 533. The through electrode 532 can be arranged at a position surrounded by the insulating separation layer 515.

As described above, according to the above-described sixth embodiment, the embedded wiring 533 embedded in the semiconductor layer 213 has a folded structure, thereby improving the stability of power supply over the entire surface of the semiconductor layer 213.

### <7. Seventh Embodiment>

In the above-described fourth embodiment, the embedded wiring 433 embedded in the semiconductor layer 213 has had a straight single structure. In this seventh embodiment, an embedded wiring embedded in a semiconductor layer 213 has a fishbone shape.

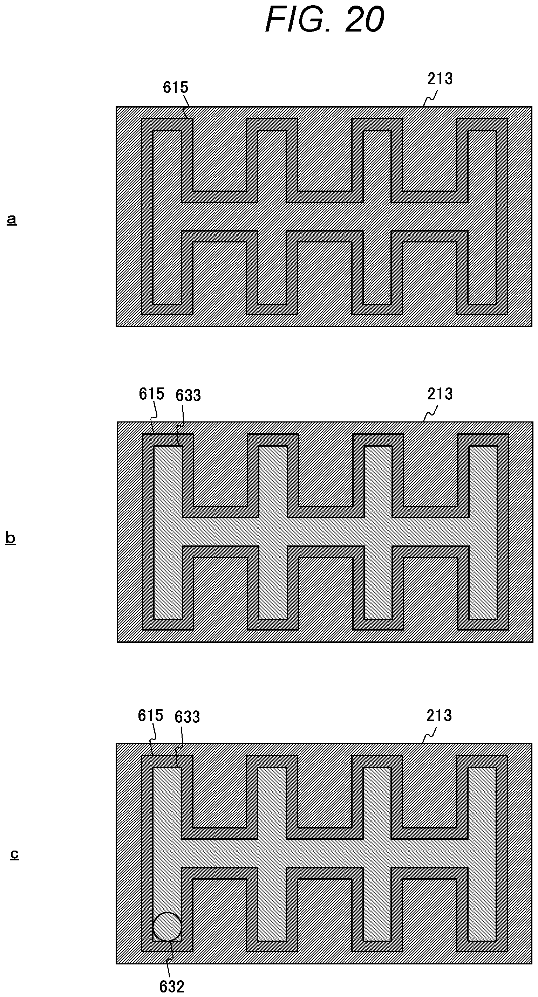

Fig. 20 is a diagram illustrating a configuration example of a semiconductor device according to the seventh embodiment. Note that a in this drawing is a cross-sectional view illustrating a configuration example of the semiconductor layer 213 after formation of an insulating separation layer 615 cut in the horizontal direction, b in this drawing is a cross-sectional view illustrating a configuration example of the semiconductor layer 213 after formation of an embedded wiring 633 cut in the horizontal direction. c in this drawing is a cross-sectional view illustrating an arrangement example of a through electrode 632 in b in this drawing.

In this drawing, the insulating separation layer 615 and the embedded wiring 633 are formed in the semiconductor layer 213. The insulating separation layer 615 can have a fishbone shape while separating the semiconductor layer 213 into the inward side and the outward side. The embedded wiring 633 is surrounded by the insulating separation layer 615. Here, by the semiconductor layer 213 inside the insulating separation layer 615 being removed, the embedded wiring 633 can be embedded in the semiconductor layer 213 in a fishbone shape. The through electrode 632 is connected to the embedded wiring 633. The through electrode 632 can be arranged at a position surrounded by the insulating separation layer 615.

As described above, in the above-described seventh embodiment, the embedded wiring 633 embedded in the semiconductor layer 213 has a fishbone shape. As a result, the stability of power feeding can be improved over the entire surface of the semiconductor layer 213, and the structure of the semiconductor layer 213 can be strengthened.

### <8. Eighth Embodiment>

In the above-described fourth embodiment, the embedded wiring 433 embedded in the semiconductor layer 213 has had a straight single structure. In this eighth embodiment, an embedded wiring embedded in a semiconductor layer 213 has a mesh shape.

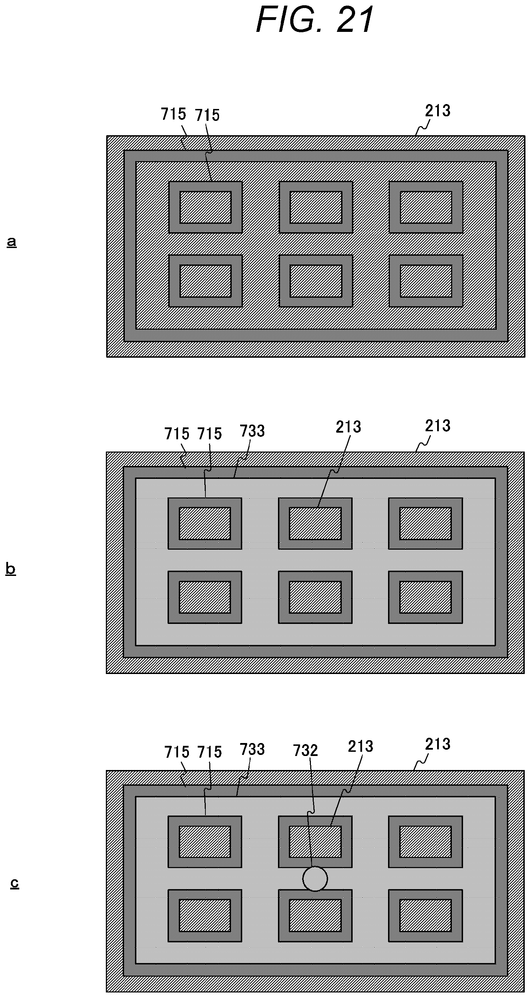

Fig. 21 is a diagram illustrating a configuration example of a semiconductor device according to the eighth embodiment. Note that a in this drawing is a cross-sectional view illustrating a configuration example of the semiconductor layer 213 after formation of insulating separation layers 715 cut in the horizontal direction, b in this drawing is a cross-sectional view illustrating a configuration example of the semiconductor layer 213 after formation of an embedded wiring 733 cut in the horizontal direction. c in this drawing is a cross-sectional view illustrating an arrangement example of a through electrode 732 in b in this drawing.

In this drawing, the insulating separation layers 715 and the embedded wiring 733 are formed in the semiconductor layer 213. The insulating separation layers 715 can separate the semiconductor layer 213 into inward sides, an outward side, and an intermediate portion therebetween, make the intermediate portion of the semiconductor layer 213 to be a mesh shape, and make the inward sides of the semiconductor layer 213 to be a plurality of isolation patterns. The embedded wiring 733 is surrounded by the insulating separation layers 715. Here, by the intermediate portion of the semiconductor layer 213 separated by the insulating separation layers 715 being removed, the embedded wiring 733 can be embedded in the semiconductor layer 213 in a mesh shape. The through electrode 732 is connected to the embedded wiring 733. The through electrode 732 can be arranged at a position surrounded by the insulating separation layers 715.

As described above, in the above-described eighth embodiment, the embedded wiring 733 embedded in the semiconductor layer 213 has a mesh shape. As a result, the stability of power feeding can be improved over the entire surface of the semiconductor layer 213, and the structure of the semiconductor layer 213 can be strengthened. Furthermore, semiconductor elements formed on the inward sides of the semiconductor layer 213 separated by the insulating separation layers 715 can be separated by the insulating separation layers 715.

### <9. Ninth Embodiment>

In the above-described first embodiment, the through electrode 132 that penetrates the semiconductor substrate 111, the intermediate insulating layer 112, and the semiconductor layer 113 and is surrounded by the sidewall insulating film 114, the intermediate insulating layer 112, and the insulating separation layer 115 has been included in the semiconductor chip 101. In this ninth embodiment, in addition to a through electrode 232 that penetrates a semiconductor substrate 211, an intermediate insulating layer 212, and a semiconductor layer 213, capacitive electrodes 833 and 835 embedded in a semiconductor layer 813 are included in a semiconductor chip 801.

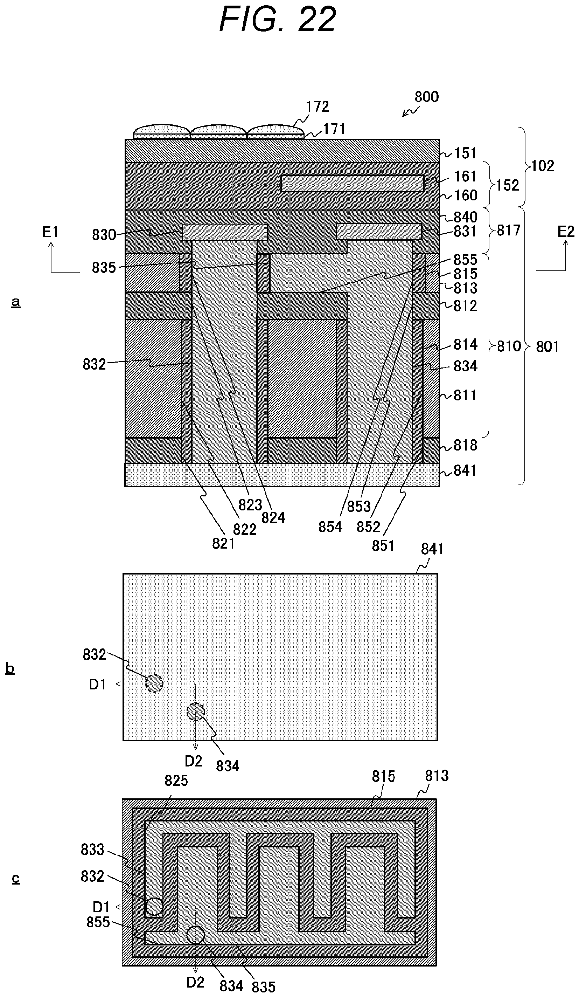

Fig. 22 is a diagram illustrating a configuration example of a semiconductor device according to the ninth embodiment. Note that a in this drawing is a cross-sectional view illustrating a configuration example of a semiconductor device 800 cut in the vertical direction, b in this drawing is a back view illustrating a configuration example of the semiconductor device 800, and c in this drawing is a cross-sectional view illustrating a configuration example of the semiconductor device 800 cut in the horizontal direction, a in this drawing is obtained by performing cutting at a position of D1-D2 in b in this drawing, c in this drawing is obtained by performing cutting at a position of E1-E2 in a in this drawing.

In this drawing, the semiconductor device 800 includes a semiconductor chip 801 instead of the semiconductor chip 101 of the above-described first embodiment. Other configurations of the semiconductor device 800 of the ninth embodiment are similar to those of the semiconductor device 100 of the above-described first embodiment.

The semiconductor chip 801 includes a semiconductor substrate 811, an intermediate insulating layer 812, and a semiconductor layer 813. The intermediate insulating layer 812 is laminated on the semiconductor substrate 811, and the semiconductor layer 813 is laminated on the intermediate insulating layer 812. As a lamination structure of the semiconductor substrate 811, the intermediate insulating layer 812, and the semiconductor layer 813, for example, an SOI substrate 810 can be used.

A semiconductor element such as a transistor is formed on the semiconductor layer 813. Furthermore, an insulating separation layer 815 that insulates and separates a part of the semiconductor layer 813 is formed on the semiconductor layer 813. The insulating separation layer 815 can be formed so as to surround a part of the semiconductor layer 813 and to divide the semiconductor layer 813. The position of the semiconductor layer 813 surrounded by the insulating separation layer 815 can correspond to formation positions of the respective capacitive electrodes 833 and 835. As the insulating separation layer 815, STI can be used. The insulating separation layer 815 penetrates the semiconductor layer 813 and reaches the intermediate insulating layer 812.

Furthermore, a wiring layer 817 is formed on the semiconductor layer 813. Pad electrodes 830 and 831 and a wiring are formed in the wiring layer 817. The pad electrodes 830 and 831 and the wiring are embedded in an insulating layer 840. A back surface insulating film 818 is formed on the back surface side of the semiconductor substrate 811.

Furthermore, through holes 821 to 824 and 851 to 854 are formed in the back surface insulating film 818, the semiconductor substrate 811, the intermediate insulating layer 812, and the semiconductor layer 813, respectively. Furthermore, cavities 825 and 855 that communicate with the respective through holes 824 and 854 are formed in the semiconductor layer 813. At this time, in the semiconductor layer 813, the through hole 824 and the cavity 825, and the through hole 854 and the cavity 855 are formed at respective positions surrounded by the insulating separation layer 815. Furthermore, in the back surface insulating film 818 and the semiconductor substrate 811, a sidewall insulating film 814 is formed on the sidewall in each of the through holes 821 and 822.

In the through holes 821 to 824, a through electrode 832 that penetrates the back surface insulating film 818, the semiconductor substrate 811, the intermediate insulating layer 812, and the semiconductor layer 813 and is connected to the capacitive electrode 833 is formed. Furthermore, in the through holes 851 to 854, a through electrode 834 that penetrates the back surface insulating film 818, the semiconductor substrate 811, the intermediate insulating layer 812, and the semiconductor layer 813 and is connected to the capacitive electrode 835 is formed. Here, in the wiring layer 817, the through electrode 832 can be in contact with the pad electrode 830, and the through electrode 834 can be in contact with the pad electrode 831. Furthermore, the capacitive electrode 833 connected to the through electrode 832 is formed in the cavity 825, and the capacitive electrode 835 connected to the through electrode 834 is formed in the cavity 855. In the semiconductor substrate 811, each of the through electrodes 832 and 834 is surrounded by the sidewall insulating film 814. Furthermore, in the semiconductor layer 813, the through electrode 832 and the capacitive electrode 833, and the through electrode 834 and the capacitive electrode 835 are surrounded by the insulating separation layer 815. At this time, each of the through electrodes 832 and 834 is insulated from the semiconductor layer 813 by the intermediate insulating layer 812 and the insulating separation layer 815, and is insulated from the semiconductor substrate 811 by the intermediate insulating layer 812 and the sidewall insulating film 814. Furthermore, each of the capacitive electrodes 833 and 835 is insulated from the semiconductor layer 813 by the insulating separation layer 815 and is insulated from the semiconductor substrate 811 by the intermediate insulating layer 812. The capacitive electrodes 833 and 835 are insulated from each other by the insulating separation layer 815. Here, at least a part of the capacitive electrodes 833 and 835 can face each other with the insulating separation layer 815 interposed therebetween. At this time, the capacitive electrodes 833 and 835 can form capacitance using the insulating separation layer 815 as a dielectric.

On the back surface insulating film 818, a protective film 841 is formed so as to cover the through electrodes 832 and 834. The material of the protective film 841 is, for example, SiN.

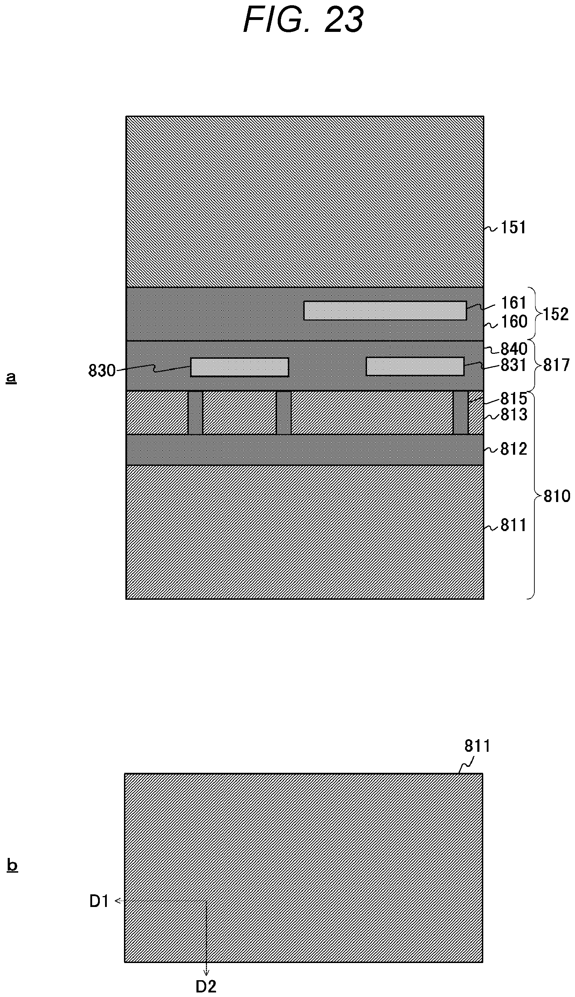

Figs. 23 to 28 are diagrams illustrating an example of a method for manufacturing the semiconductor device according to the ninth embodiment. Note that a in Figs. 23 to 28 is a cross-sectional view cut at the same position as a in Fig. 22, and b in Figs. 23 to 28 is a view seen from the back surface side of the SOI substrate in each step of a in Figs. 23 to 28.

As illustrated in Fig. 23, the insulating separation layer 815 is formed on the semiconductor layer 813 of the SOI substrate 810, and a semiconductor element such as a transistor is formed on the semiconductor layer 813. Then, the wiring layer 817 is formed on the semiconductor layer 813, and the wiring layer 817 is bonded to a wiring layer 152 by a method such as hybrid bonding.

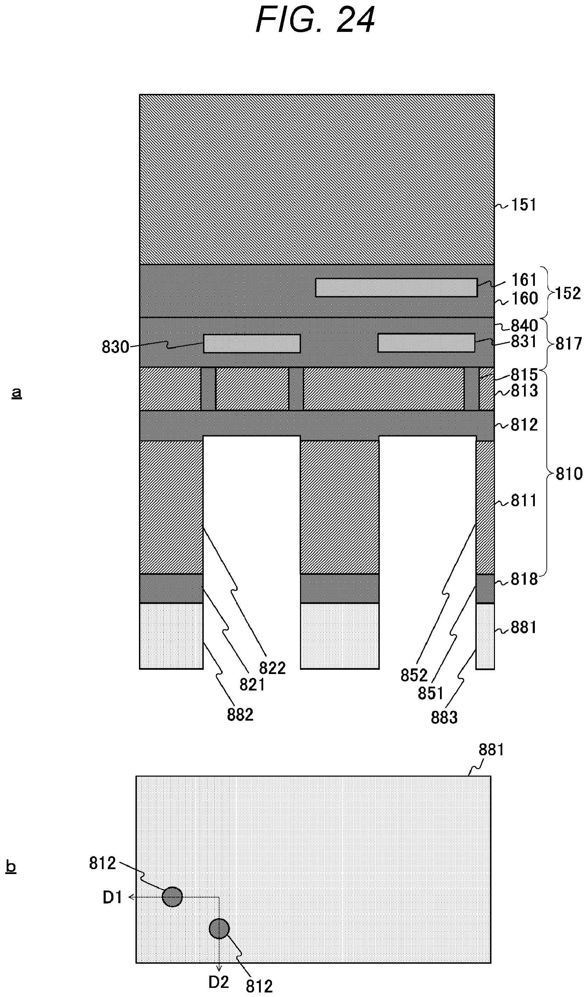

Next, as illustrated in Fig. 24, the back surface insulating film 818 is formed on the back surface side of the semiconductor substrate 811 by CVD. Moreover, a resist pattern 881 that includes openings 882 and 883 is formed on the back surface insulating film 818 by a photolithography technique. The openings 882 and 883 can be arranged at the positions of the respective pad electrodes 830 and 831 when viewed from the back surface side of the SOI substrate 810. Then, the back surface insulating film 818 and the semiconductor substrate 811 are etched using the resist pattern 881 as an etching mask to form the through holes 821 and 851 in the back surface insulating film 818, and the through holes 822 and 852 in the semiconductor substrate 811.

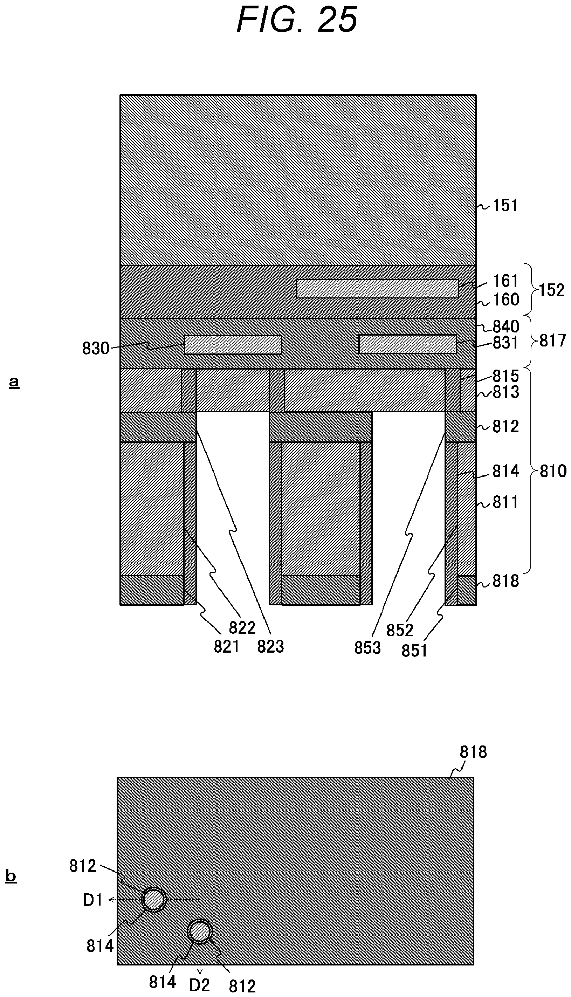

Next, as illustrated in Fig. 25, the resist pattern 881 is removed. Then, the sidewall insulating film 814 is formed by CVD, and the sidewall insulating film 814 on the back surface insulating film 818 is removed by etchback. Then, the intermediate insulating layer 812 is etched using the back surface insulating film 818 in which the through holes 821 and 851 are formed and the sidewall insulating film 814 as etching masks, thereby forming the through holes 823 and 853 in the intermediate insulating layer 812.

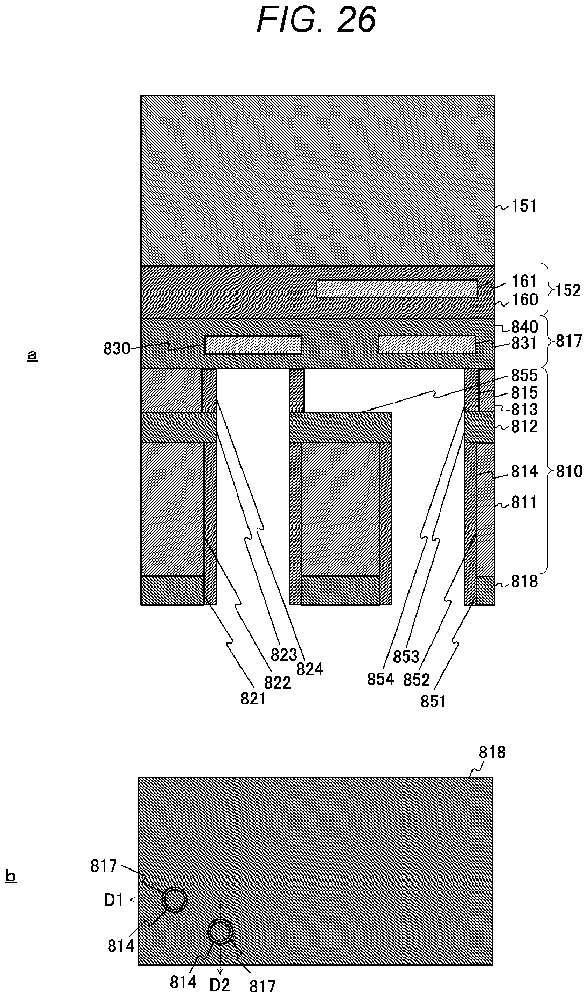

Next, as illustrated in Fig. 26, the semiconductor layer 813 is etched using the intermediate insulating layer 812 in which the through holes 823 and 853 are formed as an etching mask, thereby forming the through holes 824 and 854 and the cavities 825 and 855 in the semiconductor layer 813. Note that isotropic etching can be used for forming the through holes 824 and 854 and the cavities 825 and 855. Here, by using isotropic etching, the semiconductor layer 813 can be etched in the horizontal direction through each of the through holes 824 and 854, and the cavities 825 and 855 that communicate with the respective through holes 824 and 854 can be formed in the semiconductor layer 213. At this time, the insulating separation layer 815 and the insulating layer 840 can be used as etch stoppers.

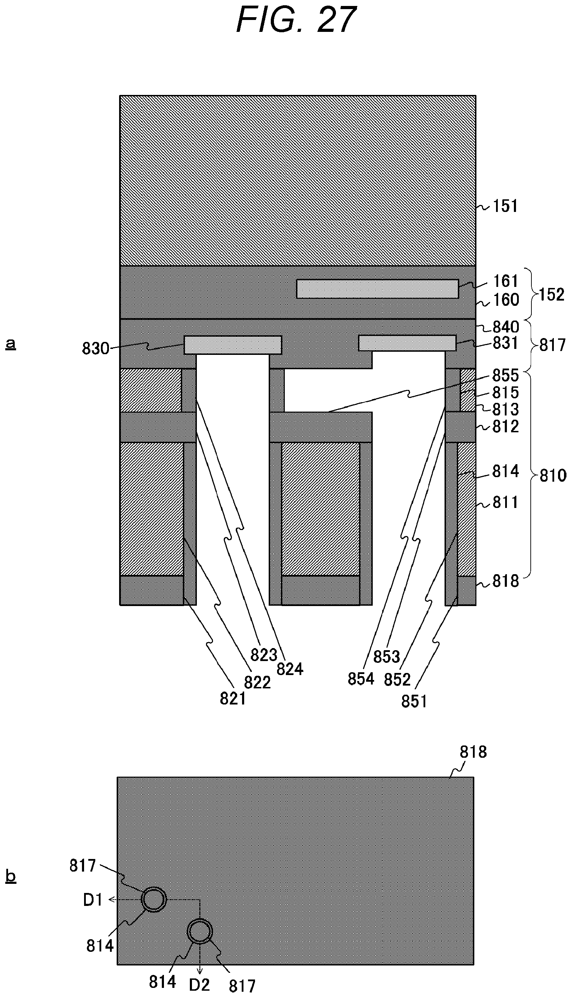

Next, as illustrated in Fig. 27, the insulating layer 840 on the back surface side of each of the pad electrodes 830 and 831 is etched through the through holes 821 to 824 and 851 to 854 to expose the back surface side of each of the pad electrodes 830 and 831.

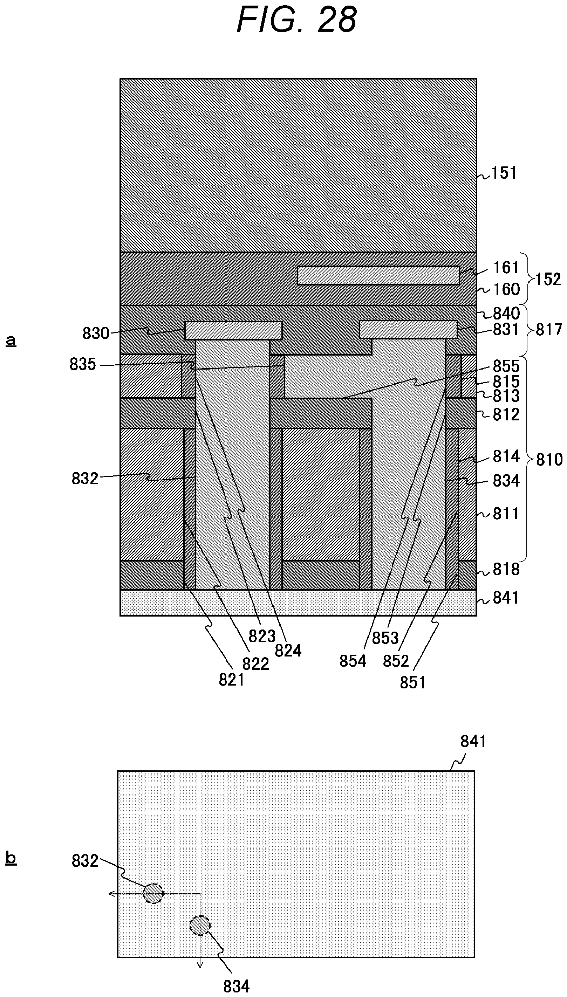

Next, as illustrated in Fig. 28, the through electrode 832 connected to the pad electrode 830 is formed in the through holes 821 to 824, and the capacitive electrode 833 connected to the through electrode 832 is formed in the cavity 825. Furthermore, the through electrode 834 connected to the pad electrode 831 is formed in the through holes 851 to 854, and the capacitive electrode 835 connected to the through electrode 834 is formed in the cavity 855. A plating layer can be used for the through electrodes 832 and 834 and the capacitive electrodes 833 and 835. Then, the through electrodes 832 and 834 are planarized by CMP to expose the back surface insulating film 818. Then, the protective film 841 is formed on the back surface insulating film 818 so as to cover the through electrodes 832 and 834 by CVD.

Next, as illustrated in Fig. 22, a semiconductor substrate 151 is thinned from the back surface side by a method such as CMP. Then, a color filter 171 is formed on the back surface side of the semiconductor substrate 151, and an on-chip lens 172 is formed on the color filter 171.

As described above, in the above-described ninth embodiment, in addition to the through electrodes 832 and 834 that penetrate the semiconductor substrate 811, the intermediate insulating layer 812, and the semiconductor layer 813, the capacitive electrodes 833 and 835 separated from each other by the insulating separation layer 815 are embedded in the semiconductor layer 813. As a result, capacitance can be increased without the area of the semiconductor layer 813 on which a semiconductor element is formed increased, and the noise resistance can be improved.

Furthermore, according to the above-described ninth embodiment, the through holes 824 and 854 and the cavities 825 and 855 can be collectively formed in the semiconductor layer 813, and the through electrodes 832 and 834 and the capacitive electrodes 833 and 835 can be collectively embedded in the semiconductor layer 813. Therefore, a step of forming the through electrodes 832 and 834 and a step of forming the capacitive electrodes 833 and 835 do not need to be separately provided, and an increase in the number of steps during forming the through electrodes 832 and 834 and the capacitive electrodes 833 and 835 can be reduced.

Note that the capacitive electrodes 833 and 835 may be locally formed in a partial region of the semiconductor layer 813. At this time, the through electrode 132 in the above-described first embodiment may be mixed in the semiconductor chip 801, or the through electrode 232 and the embedded wiring 233 in the above-described second embodiment may be mixed in the semiconductor chip 801. Furthermore, on the back surface side of the semiconductor substrate 811, the back surface wiring 133 and the pad electrode 134 in the above-described first embodiment may be formed, or the pad electrode 241 and the projecting electrode 244 in the above-described second embodiment may be formed. Furthermore, on the back surface side of the semiconductor substrate 811, the back surface wiring 346, the pad electrode 341, and the projecting electrode 344 in the above-described third embodiment may be formed.

Furthermore, the embodiments described above illustrate examples for embodying the present technology, and the matters in the embodiments and the matters specifying the invention in the claims have correspondence relationships. Similarly, the matters specifying the invention in the claims and matters with the same names in the embodiments of the present technology have correspondence relationships. However, the present technology is not limited to the embodiments, and can be embodied by applying various modifications to the embodiments without departing from the gist of the present technology. Furthermore, effects described in the present specification are merely examples and are not limited, and other effects may be provided.

Note that the present technology may also have the following configurations.
(1) A semiconductor device including:
   a semiconductor layer on which a semiconductor element is formed;
   an insulating layer on which the semiconductor layer is laminated;
   a semiconductor substrate on which the insulating layer is laminated;
   a wiring layer formed on the semiconductor layer;
   an insulating separation layer that penetrates the semiconductor layer, reaches the insulating layer, and insulates and separates a part of the semiconductor layer;
   a through electrode that penetrates the semiconductor substrate, the insulating layer, and the semiconductor layer, is connected to the wiring layer, and is surrounded by the insulating separation layer at a penetrating position of the semiconductor layer; and
   an insulating film that penetrates the semiconductor substrate, reaches the insulating layer, and is positioned between the semiconductor substrate and the through electrode.
(2) The semiconductor device according to the (1),
   in which the through electrode is
   insulated from the semiconductor layer by the insulating separation layer and the insulating layer, and
   insulated from the semiconductor substrate by the insulating film and the insulating layer.
(3) The semiconductor device according to the (2) or (3) further including an embedded wiring connected to the through electrode and embedded in the semiconductor layer in a state of being surrounded by the insulating separation layer.
(4) The semiconductor device according to any one of the (1) to (3) further including a capacitive electrode connected to the through electrode and embedded in the semiconductor layer in a state of being surrounded by the insulating separation layer.
(5) The semiconductor device according to any one of the (1) to (4) further including a semiconductor chip in which a pixel is formed on a semiconductor substrate,
   in which a logic circuit that processes a pixel signal output from the pixel is formed on the semiconductor layer, and
   the semiconductor chip is laminated on the wiring layer.
(6) The semiconductor device according to any one of the (1) to (5),
   in which a material of the semiconductor layer and the semiconductor substrate is Si.
(7) The semiconductor device according to any one of the (1) to (6),
   in which a material of the insulating layer is SiO₂.
(8) A method for manufacturing a semiconductor device, including:
   a step of forming an insulating separation layer that penetrates a semiconductor layer laminated on a semiconductor substrate with an insulating layer interposed between the semiconductor layer and the semiconductor substrate and reaches the insulating layer;
   a step of forming a semiconductor element on the semiconductor layer;
   a step of forming a first wiring layer connected to the semiconductor element on the semiconductor layer;
   a step of forming a first through hole that penetrates the semiconductor substrate and reaches the insulating layer in the semiconductor substrate;
   a step of forming an insulating film on a side wall of the first through hole;
   a step of forming a second through hole that reaches the semiconductor layer through the first through hole in the insulating layer;
   a step of forming a third through hole that reaches the first wiring layer through the first through hole and the second through hole in the semiconductor layer; and
   a step of embedding a through electrode surrounded by the insulating separation layer, the insulating layer, and the insulating film in the first through hole, the second through hole, and the third through hole.
(9) The method for manufacturing a semiconductor device according to the (8),
   in which the first through hole is formed in the semiconductor substrate on a basis of anisotropic etching,
   the second through hole is formed in the insulating layer on a basis of anisotropic etching through the first through hole, and
   the third through hole is formed in the semiconductor layer on a basis of isotropic etching through the first through hole and the second through hole.
(10) The method for manufacturing a semiconductor device according to the (8) or (9), further including:
   a step of bonding a second wiring layer of a semiconductor chip in which the second wiring layer is formed on a semiconductor substrate on which a pixel is formed to the first wiring layer; and
   a step of thinning the semiconductor substrate from a surface opposite to a formation surface of the second wiring layer.

### REFERENCE SIGNS LIST

100 Semiconductor device
101, 102 Semiconductor chip
110 SOI substrate
111, 151 Semiconductor substrate
112 Intermediate insulating layer
113 Semiconductor layer
114 Sidewall insulating film
115 Insulating separation layer
116 Gate electrode
117, 152 Wiring layer
118 Back surface insulating film
119 Protective film
121 to 124 Through hole
125 Opening
131, 161 Wiring
132 Through electrode
133 Back surface wiring
130, 134 Pad electrode
171 Color filter
172 On-chip lens

## Claims

1. A semiconductor device comprising:
a semiconductor layer on which a semiconductor element is formed;
an insulating layer on which the semiconductor layer is laminated;
a semiconductor substrate on which the insulating layer is laminated;
a wiring layer formed on the semiconductor layer;
an insulating separation layer that penetrates the semiconductor layer, reaches the insulating layer, and insulates and separates a part of the semiconductor layer;
a through electrode that penetrates the semiconductor substrate, the insulating layer, and the semiconductor layer, is connected to the wiring layer, and is surrounded by the insulating separation layer at a penetrating position of the semiconductor layer; and
an insulating film that penetrates the semiconductor substrate, reaches the insulating layer, and is positioned between the semiconductor substrate and the through electrode.

2. The semiconductor device according to claim 1,
wherein the through electrode is
insulated from the semiconductor layer by the insulating separation layer and the insulating layer, and
insulated from the semiconductor substrate by the insulating film and the insulating layer.

3. The semiconductor device according to claim 1 further comprising an embedded wiring connected to the through electrode and embedded in the semiconductor layer in a state of being surrounded by the insulating separation layer.

4. The semiconductor device according to claim 1 further comprising a capacitive electrode connected to the through electrode and embedded in the semiconductor layer in a state of being surrounded by the insulating separation layer.

5. The semiconductor device according to claim 1 further comprising a semiconductor chip in which a pixel is formed on a semiconductor substrate,
wherein a logic circuit that processes a pixel signal output from the pixel is formed on the semiconductor layer, and
the semiconductor chip is laminated on the wiring layer.

6. The semiconductor device according to claim 1,
wherein a material of the semiconductor layer and the semiconductor substrate is Si.

7. The semiconductor device according to claim 1,
wherein a material of the insulating layer is SiO₂.

8. A method for manufacturing a semiconductor device, comprising:
a step of forming an insulating separation layer that penetrates a semiconductor layer laminated on a semiconductor substrate with an insulating layer interposed between the semiconductor layer and the semiconductor substrate and reaches the insulating layer;
a step of forming a semiconductor element on the semiconductor layer;
a step of forming a first wiring layer connected to the semiconductor element on the semiconductor layer;
a step of forming a first through hole that penetrates the semiconductor substrate and reaches the insulating layer in the semiconductor substrate;
a step of forming an insulating film on a side wall of the first through hole;
a step of forming a second through hole that reaches the semiconductor layer through the first through hole in the insulating layer;
a step of forming a third through hole that reaches the first wiring layer through the first through hole and the second through hole in the semiconductor layer; and
a step of embedding a through electrode surrounded by the insulating separation layer, the insulating layer, and the insulating film in the first through hole, the second through hole, and the third through hole.

9. The method for manufacturing a semiconductor device according to claim 8,
wherein the first through hole is formed in the semiconductor substrate on a basis of anisotropic etching,
the second through hole is formed in the insulating layer on a basis of anisotropic etching through the first through hole, and
the third through hole is formed in the semiconductor layer on a basis of isotropic etching through the first through hole and the second through hole.

10. The method for manufacturing a semiconductor device according to claim 8, further comprising:
a step of bonding a second wiring layer of a semiconductor chip in which the second wiring layer is formed on a semiconductor substrate on which a pixel is formed to the first wiring layer; and
a step of thinning the semiconductor substrate from a surface opposite to a formation surface of the second wiring layer.
